# EUROPEAN PATENT APPLICATION

(11) **EP 2 037 528 A1**
(43) Date of publication of application: **18.03.2009**
(21) Application number: 07768129.4
(22) Date of filing: 04.07.2007
(51) Int. Cl.: H01M 14/00, H01L 31/04

(54) **DYE-SENSITIZED SOLAR CELL**

(30) Priority: 05.07.2006 JP 2006186111; 03.10.2006 JP 2006271939
(71) Applicant: Nippon Kayaku Kabushiki Kaisha, Tokyo 102-8172 (JP)
(72) Inventor: INOUE, Teruhisa, Tokyo 1158588 (JP); SHIGAKI, Koichiro, Tokyo 1158588 (JP); KANEKO, Masayoshi, Tokyo 1158588 (JP); HOSHI, Takayuki, Tokyo 1158588 (JP); MAENOSONO, Akira, Tokyo 1158588 (JP)
(74) Representative: Gille Hrabal Struck Neidlein Prop Roos
(86) International application number: PCT/JP2007/063371
(87) International publication number: WO 2008/004580

(57) **Abstract**

Disclosed is a solar cell **characterized by** using in combination at least two or more different photoelectric converters for specific wavelength ranges, each of which photoelectric converters is obtained by loading a thin film of oxide semiconductor particles formed on a substrate with a dye having a maximum absorption wavelength in a specific wavelength range or a salt of the dye.

## Description

### TECHNICAL FIELD

The present invention relates to a photoelectric conversion element for a specific wavelength region comprising a dye having a maximum absorption wavelength in a specific wavelength region supported on a thin film, which is provided on a substrate, of oxide semiconductor fine particles optimized for that dye, and a solar cell (Gratzel cell) which uses a combination of at least 2 such elements.

### BACKGROUND ART

Solar cells utilizing sunlight as an alternative energy source to fossil fuels such as petroleum and coal are gaining attention. Currently, development and investigation of silicon solar cells which use crystalline or amorphous silicon, or compound semiconductor solar cells which use gallium, arsenic or the like, are being enthusiastically pursued. However, because of the energy and high costs required for production, there has been the problem that it is difficult to use such solar cells in a versatile manner. Further, photoelectric conversion elements using semiconductor fine particles which have been sensitized with a dye, or solar cells using such a photoelectric conversion element, are also known. The materials and production techniques for fabricating these have been disclosed (refer to Patent Document 1, and Non-patent Documents 1 and 2). This photoelectric conversion element is produced using a relatively low-cost oxide semiconductor, such as titanium oxide. Thus, compared with a conventional solar cell which uses silicon or the like, a lower cost photoelectric conversion element can be obtained, and further, it is possible to obtain a colorful solar cell. As a result, such solar cells are attracting attention. However, compared with a silicon solar cell, the problem of a low conversion efficiency remains, so that there is a need for further improvements in conversion efficiency (refer to Patent Document 1).
As a means for resolving the above-described problems, a tandem cell which supports a plurality of dyes on a single oxide semiconductor (Patent Document 3), or a photocell in which the photoelectric conversion layer is a two-layer structure (Patent Documents 4 and 4) has been proposed. However, the problems have not yet been resolved.

Patent Document 1: Japanese Patent No. 2664194
Patent Document 2: WO 2002/011213
Patent Document 3: JP-A-2003-504799
Patent Document 4: JP-A-11-273753
Patent Document 5: JP-A-2001-167808
Non-patent Document 1: B. O'Regan et al., Nature, 353, 737 (1991)
Non-patent Document 2: M. K. Nazeeruddin et al., J. Am. Chem. Soc., 115, 6382 (1993)
Non-patent Document 3: W. Kubo et al., Chem. Lett. 1241 (1998)

### DISCLOSURE OF THE INVENTION

It is an object of the present invention to provide a photoelectric conversion element in which a material of an oxide semiconductor supporting a dye that efficiently absorbs a wavelength in a specific wavelength region is optimized to that dye, and a solar cell containing different photoelectric conversion elements optimized to different wavelengths, which has an increased photoelectric conversion efficiency over a wide wavelength region from the short-wavelength region to the long-wavelength region, especially in the short-wavelength region, which until now has very poor efficiency, and in the long-wavelength region, which has been difficult to utilize, by combining a plurality of such photoelectric conversion elements.

As a result of intensive efforts to resolve the above-described problems, the present inventors discovered that these problems can be resolved by fabricating a photoelectric conversion element which uses a dye that efficiently absorbs a specific wavelength region, and an oxide semiconductor which is optimized to this dye, and combining a plurality of these photoelectric conversion elements, thereby completing the present invention.
Specifically, the present invention relates to:
(1) A solar cell comprising a combination of at least 2 different photoelectric conversion elements for a specific wavelength region, each comprising a dye or a salt thereof having a maximum absorption wavelength in a specific wavelength region supported on a thin film of oxide semiconductor fine particles provided on a substrate;
(2) The solar cell according to (1), wherein the specific wavelength region is a wavelength region selected from a short-wavelength region, a medium-wavelength region, and a long-wavelength region;
(3) The solar cell according to (1), wherein a material of the oxide semiconductor fine particles comprises at least 1 metal species, and when 2 or more metal species are present, the metal species are combined at a specific mass ratio;
(4) A photoelectric conversion element for a specific wavelength region, comprising a dye or a salt thereof having a maximum absorption wavelength in a specific wavelength region supported on a thin film of oxide semiconductor fine particles provided on a substrate;
(5) The photoelectric conversion element according to (4), wherein a material of the oxide semiconductor fine particles comprises at least 1 metal species, and when 2 or more metal species are present, the metal species are combined at a specific mass ratio;
(6) The photoelectric conversion element according to (5), wherein in a thin film of oxide semiconductor fine particles comprising 2 or more materials, at least 1 of the materials is titanium oxide, and the mass ratio of titanium oxide in terms of the total mass of the materials of the oxide semiconductor fine particles is 70 to 98 mass%;
(7) The photoelectric conversion element according to (6), wherein the oxide semiconductor fine particles are composite oxide semiconductor fine particles of titanium oxide with an alkaline earth metal or a transition metal, or composite oxide semiconductor fine particles of titanium oxide with a metal oxide;
(8) The photoelectric conversion element according to (7), wherein the alkaline earth metal is either Mg (magnesium) or Ca (calcium), and the transition metal is any of Zr (zirconium), Nb (niobium), V (vanadium), Zn (zinc), Sn (tin), Fe (Iron), Ge (germanium), W (tungsten), or Mo (molybdenum);
(9) The photoelectric conversion element according to (7), wherein the alkaline earth metal is Sr (strontium) or Ba (barium);
(10) The photoelectric conversion element according to (8), comprising a dye or a salt thereof having a maximum absorption wavelength in a short-wavelength region of 300 to 450 nm supported on oxide semiconductor fine particles comprising a composite oxide of titanium oxide with Mg (magnesium), Ca (calcium), or Zr (zirconium);
(11) The photoelectric conversion element according to (9), comprising a dye or a salt thereof having a maximum absorption wavelength in a short-wavelength region of 300 to 450 nm supported on oxide semiconductor fine particles comprising a composite oxide of titanium oxide with Sr (strontium) or Ba (barium);
(12) A solar cell having 2 thin film layers formed from different kinds of oxide semiconductor fine particles;
(13) The solar cell according to (12), wherein either of the 2 layers is a thin film layer of composite oxide semiconductor fine particles of titanium oxide with an alkaline earth metal, a transition metal, or a metal oxide;
(14) The solar cell according to (13), wherein the composite oxide semiconductor fine particles of titanium oxide with an alkaline earth metal, a transition metal, or a metal oxide are a composite oxide semiconductor of titanium oxide with Mg (magnesium);
(15) The solar cell according to (13), comprising a dye having a maximum absorption wavelength in a short-wavelength region of 300 to 450 nm supported on composite oxide semiconductor fine particles of titanium oxide with an alkaline earth metal, a transition metal, or a metal oxide;
(16) The solar cell according to (13), having a thin film layer of complex oxide semiconductor fine particles of titanium oxide with an alkaline earth metal, a transition metal, or a metal oxide, and a thin film layer of oxide semiconductor fine particles comprising titanium oxide fine particles;
(17) A solar cell having 2 thin film layers formed from the same kind of oxide semiconductor fine particles, and 1 thin film layer formed from a different kind of oxide semiconductor fine particles;
(18) A solar cell having 3 thin film layers, each formed from different kinds of oxide semiconductor fine particles;
(19) The solar cell according to (17) or (18), wherein any one of the 3 layers is a thin film layer of complex oxide semiconductor fine particles of titanium oxide with an alkaline earth metal, a transition metal, or a metal oxide;
(20) The solar cell according to (19), comprising a dye having a maximum absorption wavelength in a short-wavelength region of 300 to 450 nm supported on complex oxide semiconductor fine particles of titanium oxide with an alkaline earth metal, a transition metal, or a metal oxide;
(21) The solar cell according to (17) or (18), wherein any one of the 3 layers is a thin film layer of oxide semiconductor fine particles comprising titanium oxide;
(22) The solar cell according to (21), comprising a dye having a maximum absorption wavelength in a medium-wavelength region of 450 to 750 nm supported on oxide semiconductor fine particles comprising titanium oxide;
(23) The solar cell according to (17) or (18), comprising different dyes or salts thereof supported on each of the 3 thin film layers formed from oxide semiconductor fine particles;
(24) The solar cell according to any one of (12), (17), or (18), wherein the 2 or more thin film layers of oxide semiconductor fine particles have respectively independent charge transport material layers, and the charge transport material of each layer is different from each others;
(25) The photoelectric conversion element according to (5), having an open-circuit voltage of 0.85 V or more; and
(26) The photoelectric conversion element according to (5), having an open-circuit voltage of 0.90 V or more.

By using a plurality of photoelectric conversion elements for different wavelength regions, a solar cell having a high conversion efficiency, especially, a high conversion efficiency in the short-wavelength region and in the long-wavelength region, can be provided.

### BEST MODE FOR CARRYING OUT THE INVENTION

The present invention will be described in detail below.
The solar cell according to the present invention is characterized by using a combination of at least 2 photoelectric conversion elements for a specific wavelength region, each comprising a dye or a salt thereof having a maximum absorption wavelength in a specific wavelength region on a thin film, provided on a substrate, of oxide semiconductor fine particles optimal for that dye. In the present specification, for the sake of convenience, unless noted otherwise the term "compound" represents a compound or salt thereof.

"Specific wavelength region" refers to 3 regions of a short-wavelength region, a medium-wavelength region, and a long-wavelength region. While it is difficult to completely classify these wavelength regions, as one example, they can be classified as follows. Specifically, the short-wavelength region is usually less than 550 nm, strictly speaking the range of 200 to 500 nm, more strictly speaking the range of 300 to 500 nm, and particularly strictly speaking the range of 300 to 450 nm.
The medium-wavelength region is the range of 400 to 900 nm, strictly speaking the range of 400 to 850 nm, more strictly speaking the range of 450 to 800 nm, and particularly strictly speaking the range of 450 to 750 nm.
The long-wavelength region is the region of wavelengths of 700 nm or longer, strictly speaking the region of wavelengths of 750 nm or longer, and more strictly speaking the region of wavelengths of 750 nm or longer.

As the dye used in the solar cell according to the present invention, any dye may be used as long as it has a maximum absorption wavelength in the above-described wavelength regions. Metal complex dyes which may be used are not especially limited. Preferred examples thereof include the ruthenium complexes disclosed in Non Patent Document 2 and ternary salts thereof, phthalocyanine, and porphyrin. Examples of organic dyes which may be used include metal-free phthalocyanines and porphyrins, cyanine, melocyanine, oxonol, triphenylmethane dyes, methine dyes such as the acrylic acid dyes described in Patent Document 2, xanthene, azo, anthraquinone, and perylene dyes. Further, preferred examples of dyes which can be used in the solar cell according to the present invention include, as methine dyes, the methine dyes described in WO 2002-011213, WO 2004-082061, International Patent Application No. PCT/JP/2007/053885, JP-A-2002-334729, JP-A-2003-007358, JP-A-2003-017146, JP-A-2003-059547, JP-A-2003-086257, JP-A-2003-115333, JP-A-2003-132965, JP-A-2003-142172, JP-A-2003-151649, JP-A-2003-157915, JP-A-2003-282165, JP-A-2004-014175, JP-A-2004-022222, JP-A-2004-022387, JP-A-2004-227825, JP-A-2005-005026, JP-A-2005-019130, JP-A-2005-135656, JP-A-2006-079898, JP-A-2006-134649, JP-A-1999-086916, JP-A-1999-163378, JP-A-1999-167937, JP-A-1999-214730, JP-A-1999-214731, JP-A-2000-106224, JP-A-2000-223167, JP-A-2000-228233, JP-A-2000-251958, JP-A-2000-277180, JP-A-2000-285978, JP-A-2000-294303, JP-A-2000-294305, JP-A-2001-006761, JP-A-2001-024253, JP-A-2001-043906, JP-A-2001-052766, JP-A-2001-067931, JP-A-2001-076773, JP-A-2001-076775, JP-A-2001-229984, JP-A-2002-042907, JP-A-2002-042908, JP-A-2002-050779, JP-A-2002-100420, JP-A-2002-164089, JP-A-2002-231325, JP-A-2002-343455, JP-A-2002-352871, JP-A-2003-007359, JP-A-2003-007360, JP-A-2003-017145, JP-A-2003-059547, JP-A-2003-078152, JP-A-2003-115333, JP-A-2003-132965, JP-A-2003-142172, JP-A-2003-147329, JP-A-2003-151649, JP-A-2003-157915, JP-A-2003-197281, JP-A-2003-203684, JP-A-2003-234133, JP-A-2003-249274, JP-A-2003-327948, JP-A-2003-346925, JP-A-2004-139755, JP-A-2003-249275, JP-A-2003-264010, JP-A-2003-282165, JP-A-2004-143355, JP-A-2004-152854, JP-A-2004-171969, JP-A-2004-200068, JP-A-2004-207224, JP-A-2004-220974, JP-A-2004-234953, JP-A-2004-235052, JP-A-2004-247158, JP-A-2004-253333, JP-A-2004-269695, JP-A-2004-292742, JP-A-2004-292743, JP-A-2004-292744, JP-A-2004-296170, JP-A-2004-319202, JP-A-2004-319309, JP-A-2005-005026, JP-A-2005-011800, JP-A-2005-019124, JP-A-2005-019249, JP-A-2005-019250, JP-A-2005-019251, JP-A-2005-0192520, JP-A-2005-019253, JP-A-2005-019756, JP-A-2005-026030, JP-A-2005-026114, JP-A-2005-026115, JP-A-2005-026116, JP-A-2005-032475, JP-A-2005-056650, JP-A-2005-056697, JP-A-2005-078887, JP-A-2005-078888, JP-A-2005-078995, JP-A-2005-085643, JP-A-2005-123013, JP-A-2005-123033, JP-A-2005-126586, JP-A-2005-129329, JP-A-2005-129429, JP-A-2005-129430, JP-A-2005-132914, JP-A-2005-135656, JP-A-2005-209359, JP-A-2005-209682, JP-A-2005-264025, and JP-A-2001-052766.
Further, examples of metal complex dyes included the complex dyes described in JP-A-2000-026487, JP-A-2000-268889, JP-A-2000-268890, JP-A-2001-006760, JP-A-2001-039995, JP-A-2001-059062, JP-A-2001-060467, JP-A-2001-060468, JP-A-2001-203005, JP-A-2001-226607, JP-A-2001-229983, JP-A-2001-236999, JP-A-2001-237000, JP-A-2001-247546, JP-A-2001-247546, JP-A-2001-253894, JP-A-2001-291534, JP-A-2002-025636, JP-A-2002-093473, JP-A-2002-093474, JP-A-2002-100417, JP-A-2002-105346, JP-A-2002-176188, JP-A-2002-193935, JP-A-2002-241634, JP-A-2003-003083, JP-A-2003-051343, JP-A-2003-051344, JP-A-2003-212851, JP-A-2003-261536, JP-A-2003-272721, JP-A-2003-288953, JP-A-2001-253894, JP-A-2004-176072, JP-A-2000-268890, JP-A-2005-120042, JP-A-2005-222941, JP-A-2005-222942, JP-A-2005-255992, JP-A-2001-039995, JP-A-2001-247546, Japanese Patent No. 2664194, Japanese Patent No. 3731752, Japanese Patent No. 3783872, Japanese Patent No. 3849005, JP-B-08-15097, and U.S. Patent No. 5,350,644.
Further, examples of dyes which can be used other than the above-described methine dyes and metal complex dyes in the above patent publications include, the dyes described in JP-A-1997-199744, JP-A-1998-051049, JP-A-1998-093118, JP-A-1998-093121, JP-A-1998-189065, JP-A-1998-334954, JP-A-1998-340742, JP-A-1999-049773, JP-A-1999-097725, JP-A-1999-204821, JP-A-1998-093118, JP-A-2000-082506, JP-A-2000-100482, JP-A-2000-100483, JP-A-2000-195570, JP-A-2000-243463, JP-A-2000-251956, JP-A-2000-251957, JP-A-2000-285976, JP-A-2001-093589, JP-A-2001-203006, JP-A-2002-042909, JP-A-2002-047290, JP-A-2002-063949, JP-A-2002-100419, JP-A-2002-184476, JP-A-2002-270865, JP-A-2002-334729, JP-A-1999-049773, JP-A-2003-007358, JP-A-2003-017146, JP-A-2003-031273, JP-A-2003-086257, JP-A-2003-123863, JP-A-2003-152208, JP-A-2003-346926, JP-A-1998-340742, JP-A-2002-0639497, JP-A-2004-143463, JP-A-2004-363096, JP-A-2002-047290, JP-A-2005-085659, and JP-A-2004-143463.

In the present application, examples of dyes which are preferred as a dye for the short-wavelength range include, among the dyes described in the above publications describing examples of methine dyes, those which, when dissolved in a polar solvent such as an alcohol, tetrahydrofuran, dimethylformamide, water, or chloroform, have a maximum absorption wavelength (λmax) located in the region of less than 550 nm, preferably 200 to 500 nm, and more preferably 300 to 500 nm. Among these, the methine dyes described in WO 2002-011213, WO 2004-082061, International Patent Application No. PCT/JP/2007/053885, JP-A-2003-059547, JP-A-2004-014175, JP-A-2004-022222, JP-A-2004-022387, JP-A-2005-005026, JP-A-2006-079898 and the like are more preferred.

In the present application, examples of dyes which are preferred as a dye for the medium-wavelength range include, among the dyes described in the above publications describing examples of methine dyes, publications describing examples of metal complex dyes, and publications describing examples of dyes other than those in the publications describing examples of methine dyes and metal complex dyes, those which, when dissolved in a polar solvent such as an alcohol, tetrahydrofuran, dimethylformamide, water, or chloroform, have a maximum absorption wavelength (λmax) located in the region of 400 to 900 nm, preferably 400 to 850 nm, more preferably 450 to 800 nm, and especially preferably 450 to 750 nm. Among these, the methine dyes described in WO 2002-011213, WO 2004-082061, International Patent Application No. PCT/JP/2007/053885, JP-A-2003-059547, JP-A-2004-014175, JP-A-2004-022222, JP-A-2004-022387, JP-A-2005-005026, JP-A-2006-079898 and the like, and the complex dyes described in Japanese Patent No. 2664194, Japanese Patent No. 3731752, Japanese Patent No. 3783872, Japanese Patent No. 3849005, JP-B-8-15097, U.S Patent No. 5,350,644 and the like are preferred, and a ruthenium dye, osmium dye complex and the like represented by the formula (2) described below are more preferred.

In the present application, examples of dyes which are preferred as a dye for the long-wavelength range include, among the dyes described in the above publications describing examples of methine dyes, publications describing examples of metal complex dyes, and publications describing examples of dyes other than those in the publications describing examples of methine dyes and metal complex dyes, those which, when dissolved in a polar solvent such as an alcohol, tetrahydrofuran, dimethylformamide, water, or chloroform, have a maximum absorption wavelength (λmax) located in the region of long wavelengths of 700 nm or more, preferably 750 nm or more, and more preferably more than 750 nm. Among these, the methine dyes described in WO 2002-011213, WO 2004-082061, International Patent Application No. PCT/JP/2007/053885 and the like, and the phthalocyanine dyes described in JP-A-2000-243464 and the like, and the cyanine dyes described in JP-A-2000-235874 and the like are preferred.

To utilize light even more efficiently, a solar cell may also be fabricated in which, in addition to the above-described dyes having a maximum absorption wavelength in the respective short-wavelength region, medium-wavelength region, and long-wavelength region, a photoelectric conversion element which uses a dye having a maximum absorption wavelength in a boundary region between the respective wavelength regions is further combined.
Further, a photoelectric conversion element including a plurality of dye kinds having different maximum absorption wavelengths in the respective regions supported on one semiconductor, or a plurality of photoelectric conversion elements each including one kind of a plurality of dye kinds having different maximum absorption wavelengths supported on the semiconductor, may be fabricated and used in combination. When comparing these two kinds of photoelectric conversion element, since the semiconductor material (metal kind) or combination of materials (metal kinds) suitable for the dye depends on the kind or chemical structure of the dye even for dyes having a maximum absorption wavelength in the same wavelength region, in the present invention it is preferred to use the latter-described photoelectric conversion element.

Examples of oxide semiconductors include composite oxides of titanium oxide with an oxide semiconductor, such as composite oxides of titanium oxide with an alkaline earth metal and titanium oxide with a transition metal, or composite oxide semiconductors of titanium oxide with a metal oxide such as zinc oxide, tin oxide and the like.
Preferred examples of composite oxide semiconductors of titanium oxide with another metal oxide which complexes therewith include composite oxide semiconductors of titanium oxide with the respective oxide of Zr (zirconium), Mg (magnesium), Ca (calcium), Sr (strontium), Ba (barium), Nb (niobium), V (vanadium), Zn (zinc), Sn (tin), Fe (Iron), Ge (germanium), W (tungsten), and Mo (molybdenum).

Among the above-described oxide semiconductors, especially preferred for the short-wavelength region are composite oxides of Ti-Zr, Ti-Mg, Ti-Ca, and Ti-Nb.
Especially preferred as an oxide semiconductor for the medium-wavelength region is titanium oxide.
Especially preferred as an oxide semiconductor for the long-wavelength region are composite oxides of titanium oxide with an oxide of Nb, V, Zn, Sn, Fe, Ge, W, Mo, Ni, Sb and the like, rutile-type titanium oxide, and zinc oxide.
An optimal combination of these oxide semiconductors may be preferably used by combining with the selected dye (e.g., combining an above-described oxide semiconductor for the short-wavelength region with an above-described dye for the short-wavelength region, combining an oxide semiconductor for the medium-wavelength region with an above-described dye for the medium-wavelength region, and combining an above-described oxide semiconductor for the long-wavelength region with an above-described dye for the long-wavelength region).
An example of an index for the optimization is the relationship between the conductor level of the semiconductor and the LUMO (lowest unoccupied molecular orbital) level of the dye. Although the LUMO level of the dye must be higher than the conductor level of the semiconductor, if it is too high the energy loss is large, and photoelectric conversion cannot be carried out efficiently. In many cases photoelectric conversion can be carried out efficiently by making the LUMO level and the conductor level closer to each other.

In the case where a composite oxide semiconductor of titanium oxide with another oxide semiconductor or another oxide is used as the oxide semiconductor, the mixing ratio between the titanium oxide and the other material (metal kind) is usually, in terms of the oxide and by mass ratio, 99:1 to 60:40, preferably 98:2 to 70:30, and especially preferably 95:5 to 75:25.

The solar cell according to the present invention is, for example, characterized by using a combination of at least 2 photoelectric conversion elements for a specific wavelength region comprising a dye or a salt thereof having a maximum absorption wavelength in a specific wavelength region supported on a thin film of oxide semiconductor fine particles provided on a substrate.
In the present invention, the substrate on which the thin film of oxide semiconductor fine particles is provided preferably has a conductive surface. Such a substrate can be easily obtained commercially.
Specifically, substrates provided with a thin film of a conductive metal oxide, such as tin oxide, doped with indium, fluorine or antimony, or thin film of a metal such as copper, silver, and gold, on a glass surface or the surface of a transparent polymer material such as polyethylene terephthalate or polyethersulfone, can be used. The conductivity may usually be 1000 Ω or less, and 100 Ω or less is especially preferred.
Further, a metal oxide is preferred for the fine particles of the oxide semiconductor. Preferred specific examples thereof include fine particles of the above-described oxide semiconductors. An above-described oxide semiconductor may also be used by additionally coating on the surface of the semiconductor.
Further, the average particle size of the fine particles of the oxide semiconductor is usually 1 to 500 nm, and preferably 1 to 100 nm. Moreover, the fine particles of the oxide semiconductor may also be used in the form of a mixture of particles having a large particle size and particles having a small particle size, and in a multi-layer form.

The thin film of oxide semiconductor fine particles may be produced by a method in which the oxide semiconductor fine particles are directly formed on a substrate as a thin film of semiconductor fine particles by spraying etc., a method in which the semiconductor fine particles are electrically deposited in a thin film form using the substrate as an electrode, or a method in which a slurry of semiconductor fine particles or a paste containing fine particles obtained by hydrolyzing a precursor of the semiconductor fine particles, such as a semiconductor alkoxide, is coated on the substrate, then dried, hardened, or baked. In terms of the performance of an electrode using the oxide semiconductor, the method in which a slurry is used is preferred. When using this method, the slurry may be obtained by dispersing secondary-agglomerated oxide semiconductor fine particles by a typical method in a dispersion medium so that the average primary particle size is 1 to 200 nm.

The dispersion medium dispersing slurry therein may be any medium which can disperse semiconductor particles. Examples thereof which may be used include water, alcohols such as ethanol and terpineol, ketones such as acetone and acetylacetone, and hydrocarbons such as hexane. These mediums may be used as a mixture. Water is preferred from the standpoint that it reduces the change in viscosity of the slurry. Further, in order to stabilize the dispersion state of the oxide semiconductor fine particles, a dispersion stabilizer can be used. Examples of dispersion stabilizers which can be used include an acid such as acetic acid, hydrochloric acid, and nitric acid, or an organic solvent such as acetylacetone, acrylic acid, polyethylene glycol, polyvinyl alcohol and the like.

The substrate coated with the slurry may be baked. The baking temperature is usually 100°C or more, and preferably 200°C or more. The upper limit thereof is roughly the melting point (softening point) of the substrate or less. Usually the upper limit is 900°C, and preferably 600°C or less. Although the baking time is not especially limited, within about 4 hours is preferable. The thickness of the thin film on the substrate is usually 1 to 200 µm, and preferably 1 to 50 µm.

The thin film of oxide semiconductor fine particles may be subjected to a secondary treatment. Specifically, for example, by directly dipping the whole substrate on which the thin film of oxide semiconductor fine particles is provided, in a solution of an alkoxide, metal acyloxide, chloride, nitrate, sulfate and the like of the same metal as the semiconductor, and then drying or re-baking, the performance of the thin film of semiconductor fine particles can be improved. Examples of the metal alkoxide include titanium ethoxide, titanium isopropoxide, and titanium t-butoxide. Examples of the metal acyloxide include n-dibutyl-diacetyl tin. An alcohol solution thereof may be used. An acetate or chloride may also be used. Examples of the chloride include titanium tetrachloride, tin tetrachloride, and zinc chloride. An aqueous solution thereof may be used. When using an acetate, magnesium acetate, calcium acetate, zinc acetate and the like may be used.
The thus-obtained oxide semiconductor thin film is constituted of fine particles of the oxide semiconductor.

Next, the method for supporting the dye on the thin film of oxide semiconductor fine particles will be described.
Examples of the method for supporting the dye include dipping the substrate on which the above-described thin film of oxide semiconductor fine particles is provided in a solution obtained by dissolving the dye in a solvent in which it can dissolve, or in a dispersion obtained by dispersing the dye if the dye has low solubility. The concentration in the solution or dispersion is appropriately determined according to the dye. The thin film of semiconductor fine particles fabricated on a substrate is dipped into this solution. The dipping temperature is from about room temperature to boiling point of the solvent. The dipping time is from about 1 minute to 48 hours. Specific examples of solvents which can be used to dissolve the dye include methanol, ethanol, acetonitrile, dimethylsulfoxide, dimethylformamide, acetone, and t-butanol. The dye concentration in the solution is usually 1 × 10⁻⁶ M to 1 M, and preferably 1 × 10⁻⁵ M to 1 × 10⁻¹ M. In this manner, the photoelectric conversion element according to the present invention having a thin film of oxide semiconductor fine particles, which have been sensitized with a dye, can be obtained.

The supported dye may be one kind, or a mixture of several kinds. By mixing dyes with different absorption wavelength regions within a specific wavelength region, in some cases a wider absorption wavelength region can be utilized than that for a single dye, so that a solar cell with high conversion efficiency can be obtained. When 2 or more kinds of dye are used, these dyes may be adsorbed sequentially on the thin film of semiconductor fine particles, or adsorbed after dissolving them by mixing.

The ratio of the mixed dyes is not especially limited. Although the optimizing conditions are appropriately selected depending on the respective dyes, generally it is preferred to mix from equivalent molar ratios of each dye to a ratio of about 10 mole% or more per dye. When the dyes are adsorbed on the thin film of oxide semiconductor fine particles using a solution in which 2 or more kinds of dye are dissolved or dispersed, the total concentration of the dyes in the solution may be the same as a case where only one kind of dye is supported. As the solvent for when the dyes are used in a mixture, a solvent such as those as described above can be used. The solvent for each used dye may be the same or different.

When supporting the dyes on the thin film of oxide semiconductor fine particles, to prevent the dyes from associating with one another, it is effective to support the dyes in the presence of an inclusion compound. Examples of the inclusion compound include steroidal compounds such as cholic acid, crown ethers, cyclodextrin, calixarene, and polyethylene oxide. Preferred examples include cholic acids such as deoxycholic acid, dehydrodeoxycholic acid, chenodeoxycholic acid, methyl cholate, and sodium cholate, and polyethylene oxide. Further, after the dyes are supported, the thin film of semiconductor fine particles may be treated with an amine compound such as 4-t-butylpyridine. The method employed for such a treatment may be, for example, a method in which the substrate on which the thin film of semiconductor fine particles supporting the dye is provided is dipped in a solution of an amine in ethanol, or the like.

The solar cell according to the present invention includes a photoelectric conversion element electrode comprising a dye on the above-described thin film of oxide semiconductor fine particles, a counter electrode, and a charge transport material formed from a redox electrolyte, a hole transport material, or a p-type semiconductor and the like. Examples of the form of the redox electrolyte, hole transport material, p-type semiconductor and the like include a liquid, an agglomerate (gel and gel-like), and a solid. Examples of liquid forms include a solution in which a redox electrolyte, a molten salt, a hole transport material, a p-type semiconductor and the like are respectively dissolved in a solvent, an ordinary-temperature molten salt and the like. Examples of agglomerate forms (gel and gel-like) include an agglomerate in which they are included in a polymer matrix or a low molecular weight gelling agent and the like. As a solid, the redox electrolyte, the molten salt, the hole transport material, the p-type semiconductor and the like may be used. Examples of hole transport materials include amine derivatives, conductive polymers such as polyacetylene, polyaniline, and polythiophene, and materials using a discotic liquid crystal phase such as a triphenylene compound. Further, examples of p-type semiconductors include CuI and CuSCN.

The counter electrode preferably is conductive and works as a catalyst to the reduction reaction of the redox electrolyte. Examples of counter electrodes which can be used include glass or a polymer film on which platinum, carbon, rhodium, ruthenium or the like are vapor-deposited, or conductive fine particles are applied.

Examples of redox electrolytes used in the solar cell according to the present invention include a halogen redox electrolyte composed of a halogen molecule and a halogen compound having a halogen ion as a counter ion, a metal redox electrolyte of a metal complex or the like such as ferrocyanate-ferricyanate, ferrocene-ferricinium ion, and a cobalt complex, an organic redox electrolyte such as alkylthiol-alkyldisulfide, a viologen dye, and hydroquinone-quinone. A halogen redox electrolyte is preferred. Examples of the halogen molecule in the halogen redox electrolyte composed of a halogen compound-halogen molecule include an iodine molecule and a bromine molecule. An iodine molecule is preferred. Further, examples of the halogen compounds having a halogen ion as a counter ion include a halogenated metal salt such as LiBr, NaBr, KBr, LiI, NaI, KI, CsI, CaI₂, MgI₂, and CuI, or an organic quaternary ammonium salt of a halogen such as tetraalkylammonium iodide, imidazolium iodide, and pyridinium iodide. A salt having an iodine ion as a counter ion is preferred. Further, in addition to the above-described iodine ions, an electrolyte having an imide ion such as a bis(trifluoromethanesulfonyl)imide ion, a dicyanoimide ion as a counter ion may also be preferably used.

In addition, in the case where the redox electrolyte is in the form of a solution in which it is contained, an electrochemically inert solvent is used. Examples include acetonitrile, propylene carbonate, ethylene carbonate, 3-methoxypropionitrile, methoxyacetonitrile, ethylene glycol, propylene glycol, diethylene glycol, triethylene glycol, γ-butyrolactone, dimethoxyethane, diethyl carbonate, diethyl ether, diethyl carbonate, dimethyl carbonate, 1,2-dimethoxyethane, dimethylformamide, dimethylsulfoxide, 1,3-dioxolane, methyl formate, 2-methyltetrahydrofuran, 3-methyl-oxazolidin-2-one, sulfolane, tetrahydrofuran, and water. Among these, acetonitrile, propylene carbonate, ethylene carbonate, 3-methoxypropionitrile, methoxyacetonitrile, ethylene glycol, 3-methyl-oxazolidin-2-one, γ-butyrolactone and the like are especially preferable. These solvents may be used alone or as a mixture of 2 or more kinds. In the case of a gel-like electrolyte, examples of the gel-like electrolyte include a gel-like electrolyte having an electrolyte or an electrolytic solution in a matrix such as an oligomer or a polymer, and a gel-like electrolyte similarly having an electrolyte or an electrolytic solution in a low molecular weight gelling agent and the like, as described in Non-patent Document 3. The concentration of the redox electrolyte is usually 0.01 to 99 weight%, and preferably about 0.1 to 90 weight%.

When the solar cell of the present invention has a plurality of independent charge transport material layers, each of the charge transport materials with which these charge transport material layers are filled may be the same or different. In particular, since the dyes and semiconductors for the short-wavelength region, the medium-wavelength region, and the long-wavelength region of the solar cell of the present invention each have different energy levels, it is preferred to use charge transport materials which is appropriately selected for each of these regions.

In the solar cell according to the present invention, a counter electrode and the electrode provided on a photoelectric conversion element where the dye is supported on the thin film of oxide semiconductor fine particles on the substrate are arranged so as to sandwich the thin film of oxide semiconductor fine particles. The solar cell is obtained by charging a solution containing the redox electrolyte into a gap therebetween.

### EXAMPLES

The present invention will now be described in more detail based on the following examples. However, the present invention is not limited to these examples. In the examples, unless otherwise specified, the term "part(s)" represents "part(s) by mass".
Maximum absorption wavelength was measured with a V-3150 spectrophotometer (manufactured by Shimadzu Corporation), and nuclear magnetic resonance was measured with a Gemini 300 (manufactured by Varian Inc.).
The structural formulae of the CMY-003, CMO-007, and N719 used in the examples are represented below.
N719 may be commercially purchased as a commercial product. CMY-003 and CMO-007 were synthesized according to Example 1 in WO 2002/011213.
The maximum absorption wavelengths of the above-described dyes in ethanol were as follows.

| Dye | Maximum absorption wavelength (nm) |
|---|---|
| N719 | 532 |
| CMY-003 | 386 |
| CMO-007 | 417 |

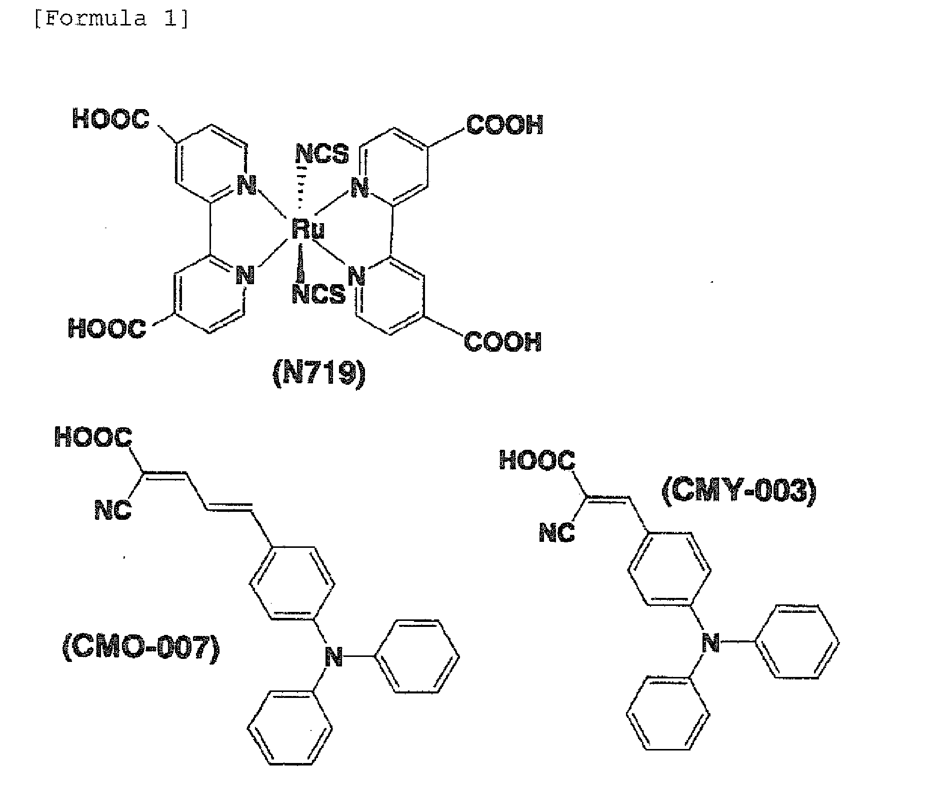

### Example 1

Titanium isopropoxide (25 g) and magnesium acetate tetrahydrate (2.5 g) were suspended in 1,4-butanediol (130 mL). The resultant mixture was placed in an autoclave having a volume of 300 mL, and the autoclave was then sealed. The contents of the autoclave were purged with nitrogen, and then the temperature in the autoclave was increased by heating to 300°C. After 2 hours, the autoclave valve was opened while maintaining the temperature at 300°C to remove the solvent, whereby 7.0 g of semiconductor fine particles composed of an oxide semiconductor of titanium oxide and magnesium was obtained as a xerogel.

### Examples 2 to 9

Various kinds of oxide semiconductor fine particles were obtained by the same procedures as in Example 1. These results including Example 1 are collectively shown in Table 1. In Table 1, "Other Material" represents the material corresponding to the magnesium acetate tetrahydrate in Example 1.

**[Table 1]**

| Example Number | Titanium Isopropoxide | Other Material | Yield (g) |
|---|---|---|---|
| | | Magnesium Acetate Tetrahydrate | |
| 1 | 25 g | 2.5 g | 7.0 g |
| 2 | 25 g | 5.0 g | 7.2 g |
| 3 | 25 g | 7.5 g | 8.2 g |
| | | Calcium Acetate Hydrate | |
| 4 | 25 g | 2.5 g | 7.3 g |
| 5 | 25 g | 5.0 g | 7.5 g |
| 6 | 25 g | 10.0 g | 7.9 g |
| | | Zirconium Isopropoxide | |
| 7 | 25 g | 6.3 g | 7.6 g |
| 8 | 25 g | 12.5 g | 8.1 g |
| 9 | 25 g | 18.8 g | 10.0 g |

The respective semiconductor fine particles obtained in Examples 1 to 9 were formed into a paste using terpineol. These pastes were coated on the conductive substance FTO of a conductive glass support (glass substrate), which is the conductive support of the solar cell. The coated substrates were baked for 30 minutes at 450°C to obtain a porous substrate. Further, porous substrates were also produced in the same manner using titanium oxide and zinc oxide individually.
Next, the above-described CMY-003, CMO-007, and N719 dyes were dissolved in ethanol (EtOH) so as to each form a 3.2 × 10⁻⁴ M solution. A porous substrate obtained in the above-described manner (a thin film of a semiconductor formed by baking porous titanium oxide on a transparent conductive glass electrode for 30 minutes at 450°C) was then dipped in this solution at room temperature (20°C) for 12 hours, so that the respective dyes were supported thereon. The substrate was washed with a solvent (ethanol), and then dried to obtain a photoelectric conversion element constituted of a thin film of dye-sensitized semiconductor fine particles.
On a substrate provided with the thus-obtained thin film of dye-sensitized semiconductor fine particles, conductive glass sputtered with platinum was fixed leaving a space of 20 micrometers in such way that a sputtered surface of the conductive glass was opposed to the thin film of semiconductor fine particles. A solution (electrolytic solution) containing an electrolyte was injected into that space. For the electrolytic solution, as "electrolytic solution A", a solution in which iodine/lithium iodide/1,2-dimethyl-3-n-propylimidazolium iodide/t-butylpyridine were dissolved in 3-methoxypropionitrile in concentrations of 0.1 M/0.1 M/0.6 M/1 M, respectively, was used, and as "electrolytic solution B", iodine/tetra-n-propylammonium iodide was prepared in ethylene carbonate/acetonitrile (4/6) in concentrations of 0.05 M/0.5 M, respectively.
Each of the thus-obtained solar cells using the respective photoelectric conversion elements which form the solar cell according to the present invention had been tested about their performance under the following conditions.
The size of the cell to be measured was 0.25 cm² in effective area. A light source of 100 mW/cm² was employed by using a 500 W xenon lamp through an AM (air mass passing through the atmosphere) 1.5 filter. Short-circuit current, open-circuit voltage, and conversion efficiency were measured using a Solar Simulator WXS-155S-10, AM 1.5 G (manufactured by Wacom Electric Co., Lid.).
The measurement results are shown in Tables 2 to 4. Table 2 shows the test results of cells using N791; Table 3 shows the test results of cells using CMY-003, and Table 4 shows the test results of cells using CMO-007. Here, the substrate numbers 1 to 9 listed in each table respectively denote that the porous substrates produced using the various kinds of oxide semiconductor fine particles prepared in the above Examples 1 to 9 were used. Further, substrate numbers 10 and 11 respectively denote that porous substrates of titanium oxide and zinc oxide produced in the same manner were used.

**[Table 2]**

| Dye | Substrate Number | Short-circuit Current *J*_{SC}(mA/cm²) | Open-circuit Voltage *V*_{OC}(V) | Form Factor *ff* | Conversion Efficiency η(%) |
|---|---|---|---|---|---|
| N719 | 1 | 7.78 | 0.75 | 0.74 | 4.4 |
| | 2 | 7.79 | 0.75 | 0.75 | 4.4 |
| | 3 | 1.51 | 0.65 | 0.77 | 0.8 |
| | 4 | 9.44 | 0.69 | 0.62 | 4.1 |
| | 5 | 2.77 | 0.72 | 0.74 | 1.5 |
| | 6 | 0.97 | 0.67 | 0.65 | 0.4 |
| | 7 | 0.52 | 0.72 | 0.77 | 0.3 |
| | 8 | 0.07 | 0.60 | 0.24 | 0.0 |
| | 9 | 0.03 | 0.55 | 0.00 | 0.0 |
| | 10 | 6.45 | 0.67 | 0.72 | 3.1 |
| | 11 | 3.28 | 0.58 | 0.40 | 0.8 |

It can be clearly understood from the results of Table 2 that, in the case of N719 having a maximum absorption wavelength in the medium-wavelength range, a semiconductor formed from titanium and magnesium, like in substrate numbers 1 and 2, has the best match as the metal kinds, and that the open-circuit voltage and photoelectric conversion efficiency are the highest. When the dye has a maximum absorption wavelength in the medium-wavelength range, the matches with titanium oxide are usually excellent. However, since N719 is characterized by having a relatively broad absorption wavelength, it can be considered that a combination of the above metal kinds exhibited higher performance than a semiconductor in which titanium oxide was used by itself. Thus, even for a dye in which the maximum absorption wavelength is present in the medium-wavelength range, if a broad absorption is shown, titanium oxide may not always be the best. Therefore, the semiconductor materials etc. need to be appropriately investigated.
Further, even when the same metal kind was used, from a comparison of substrate number 3 with substrate numbers 1 and 2, it can be seen that a preferred mixing ratio of the two kinds of metal exists.
These can be used in the solar cell according to the present invention as a cell for the medium-wavelength region.

**[Table 3]**

| Dye | Substrate Number | Short-circuit Current *J*_{SC}(mA/cm²) | Open-circuit Voltage *V*_{OC}(V) | Form Factor *ff* | Conversion Efficiency η(%) |
|---|---|---|---|---|---|
| CMY-003 | 1 | 3.11 | 0.91 | 0.75 | 2.1 |
| | 2 | 2.47 | 0.92 | 0.80 | 1.8 |
| | 3 | 1.27 | 0.78 | 0.83 | 0.8 |
| | 4 | 6.19 | 0.77 | 0.77 | 3.7 |
| | 5 | 3.37 | 0.79 | 0.74 | 2.0 |
| | 6 | 1.29 | 0.75 | 0.76 | 0.7 |
| | 7 | 0.48 | 0.76 | 0.74 | 0.3 |
| | 8 | 0.08 | 0.52 | 0.48 | 0.0 |
| | 9 | 0.05 | 0.48 | 0.42 | 0.0 |
| | 10 | 2.41 | 0.73 | 0.70 | 1.2 |
| | 11 | 3.25 | 0.57 | 0.62 | 1.2 |

It can be clearly understood from the results of Table 3 that, in the case of CMY-003 having a maximum absorption wavelength in the short-wavelength range, a semiconductor formed from titanium and magnesium or from titanium and calcium, like in substrate numbers 1, 2, 4, and 5, has the best match as the metal kinds, and that the open-circuit voltage and photoelectric conversion efficiency are high.
However, even when the same metal kind was used, from a comparison of substrate number 3 with substrate numbers 1 and 2, or a comparison of substrate number 6 with substrate numbers 4 and 5, it can be seen that a preferred mixing ratio of the two kinds of metal does in fact exist.
These can be used in the solar cell according to the present invention as a cell for the short-wavelength region.

**[Table 4]**

| Dye | Substrate Number | Short-circuit Current *J*_{SC}(mA/cm²) | Open-circuit voltage *V*_{OC}(V) | Form Factor *ff* | Conversion Efficiency η(%) |
|---|---|---|---|---|---|
| CMO-007 | 1 | 4.51 | 0.89 | 0.76 | 3.1 |
| | 2 | 4.09 | 0.90 | 0.79 | 2.9 |
| | 3 | 1.29 | 0.76 | 0.81 | 0.8 |
| | 4 | 7.03 | 0.83 | 0.73 | 4.4 |
| | 5 | 3.73 | 0.83 | 0.76 | 2.4 |
| | 6 | 0.95 | 0.75 | 0.79 | 0.6 |
| | 7 | 0.56 | 0.91 | 0.84 | 0.4 |
| | 8 | 0.03 | 0.44 | 0.00 | 0.0 |
| | 9 | 0.02 | 0.47 | 0.00 | 0.0 |
| | 10 | 3.02 | 0.75 | 0.70 | 1.6 |
| | 11 | 7.87 | 0.56 | 0.45 | 0.2 |

It can be clearly understood from the results of Table 4 that, like in the case of CMY-003, in the case of CMO-007 having a maximum absorption wavelength in the short-wavelength range as well, a semiconductor formed from titanium and magnesium or from titanium and calcium, like in substrate numbers 1, 2, 4, and 5, has the best match as the metal kinds, and that the open-circuit voltage and photoelectric conversion efficiency are high.
Further, even when the same metal kind was used, from a comparison of substrate number 3 with substrate numbers 1 and 2, or a comparison of substrate number 6 with substrate numbers 4 and 5, it can be seen that a preferred mixing ratio of the two kinds of metal does in fact exist.
On the other hand, when focusing on open-circuit voltage, the case of substrate number 7, where a semiconductor formed from titanium and zirconium was used, showed the highest value. This is a characteristic which was not seen for CMY-003.
These can be used in the solar cell according to the present invention as a cell for the short-wavelength region.

Since the light in the short-wavelength region is high energy, if the light in this region can be efficiently used, as a result a solar cell exhibiting high voltage can be obtained. Therefore, by respectively utilizing the voltage in the short-wavelength region, and the voltage and current in other wavelength regions, such as the medium-wavelength region, as well as the current in the long-wavelength region, which conventionally has been difficult to utilize, energy from a wider wavelength region can be efficiently acquired.

By combining the above-described solar cells for the medium-wavelength region and short-wavelength region, and a solar cell for the long-wavelength region, the solar cell according to the present invention can be fabricated. Normal connection methods, such as in series, parallel, series-parallel, may be utilized as the combination method.
When using a plurality of solar cells for various wavelength regions having the same surface area together, the structure may be formed so that high energy light is absorbed in order from the side nearer to the incident face of the light, for instance from the cell for the short-wavelength region, the cell for the medium-wavelength region, and then the cell for the long-wavelength region. As a result, the solar cell according to the present invention can efficiently utilize light in a wider wavelength region than that of conventional solar cells.

A fabrication method of a tandem solar cell and the evaluation results of the cell performance thereof will now be described in order. When making into a tandem solar cell, the cell is formed by combining photoelectric conversion elements for the short-wavelength region, the medium-wavelength region, and the long-wavelength region, or by combining solar cells having such photoelectric conversion elements. Thus, if conductive glass sputtered with platinum is used as one of the electrodes, since the transmission of light is suppressed by such electrode, it becomes more difficult for the light to be transmitted beyond such electrode. Therefore, for a tandem solar cell, it is preferred to use a platinum mesh or a carbon mesh sputtered with platinum instead of using conductive glass sputtered with platinum.

### Example 12

### Fabrication of a Tandem Solar Cell (2 Cell Type)

On each of porous substrates with substrate numbers of 1 to 11 obtained in the manner described above, a thin film of semiconductor fine particles of a photoelectric conversion element where CMY-003 or CMO-007 was supported as a dye was set leaving a space of 20 micrometers so as to oppose one face ("first face") of a platinum mesh and it was fixed. In the same manner, on a porous substrate with a substrate number of 10 obtained in the manner described above, a thin film of semiconductor fine particles of a photoelectric conversion element where N719 was supported as a dye was set leaving a space of 20 micrometers so as to oppose the other face ("second face") of the mesh, and it was fixed.
A solution (electrolytic solution) containing an electrolyte was injected into these respective spaces. For the electrolytic solution, a solution in which iodine/lithium iodide/1,2-dimethyl-3-n-propylimidazolium iodide/t-butylpyridine were dissolved in 3-methoxypropionitrile in concentrations of 0.1 M/0.1 M/0.6 M/1 M, respectively, was used.
The cell performance of the thus-obtained tandem solar cells according to the present invention was tested by the same test methods as described above.
The results are shown in Table 5.

### Example 13

### Fabrication of a Tandem Solar Cell (3 Cell Type)

The fabrication method of a 3 cell type tandem solar cell will now be described. Used for the dye having a maximum absorption wavelength in the long-wavelength region was NKC-001 represented by the following formula (2). The maximum absorption wavelength of NKC-001 in dichloroethane was 1060 nm.

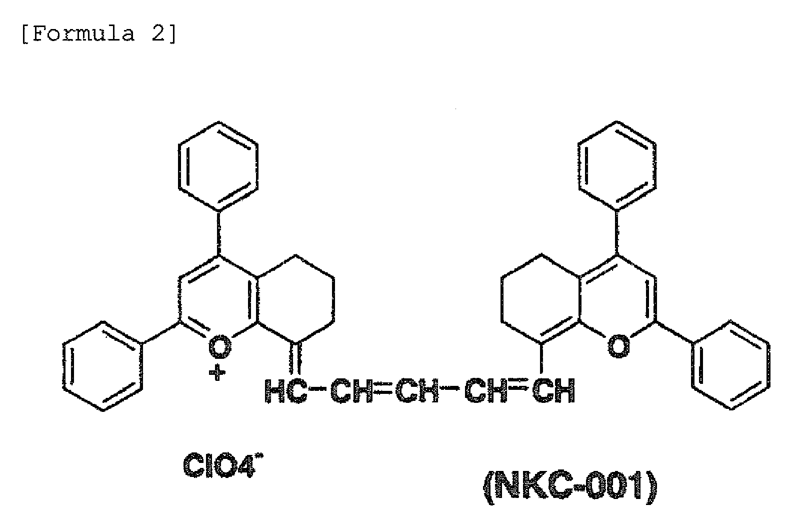

(1) Titanium oxide formed into a paste using terpineol was coated on one face on the conductive substance FTO of a conductive glass support (glass substrate), which is the conductive support of the solar cell, and tin oxide formed into a paste using terpineol was coated on the other face. The coated substrates were baked for 30 minutes at 450°C to obtain a porous substrate having a thin film of semiconductor fine particles on either face of one sheet of a conductive glass support (glass substrate). The obtained porous substrate was numbered as substrate number 12.
(2) Next, the N719 dye was dissolved in ethanol (EtOH) so as to form a 3.2 × 10⁻⁴ M solution. The titanium oxide face only of the substrate number 12 obtained in the above-described manner was then dipped in this solution at room temperature (20°C) for 12 hours so that the dye was supported thereon. The porous substrate was washed with a solvent (ethanol), and then dried.
   Further, the NKC-001 dye represented by formula (2) was dissolved in ethanol (EtOH) so as to form a 3.2 × 10⁻⁴ M solution. The tin oxide face only of the substrate number 12 obtained in the above-described manner was then dipped in this solution at room temperature (20°C) for 12 hours so that the dye was supported thereon. The porous substrate was washed with a solvent (ethanol), and then dried to obtain a photoelectric conversion element constituted of a thin film of dye-sensitized semiconductor fine particles on either face of one sheet of a conductive glass support (glass substrate).
(3) A thin film of semiconductor fine particles of a photoelectric conversion element fabricated using the respective substrates with substrate numbers of 1 to 11 obtained in the manner described above was fixed leaving a space of 20 micrometers so as to oppose one face ("first face") of a platinum mesh. In the same manner, the face on the side of the thin film of semiconductor fine particles of titanium oxide of the photoelectric conversion element fabricated using the substrate with substrate number of 12 obtained in the manner described above was set leaving a space of 20 micrometers so as to oppose the other face ("second face") of the mesh, and it was fixed.

Further, the sputtered face of a conductive glass sputtered with platinum was set leaving a space of 20 micrometers so as to oppose the other face of substrate number 12, that is, the face having a thin film of semiconductor fine particles of tin oxide, and it was fixed.

The respective spaces were then filled by injecting them with a solution (electrolytic solution) containing an electrolyte. For the electrolytic solution, a solution in which iodine/lithium iodide/1,2-dimethyl-3-n-propylimidazolium iodide/t-butylpyridine were dissolved in 3-methoxypropionitrile in concentrations of 0.1 M/0.1 M/0.6 M/1 M, respectively, was used.

The cell performance of the thus-obtained tandem solar cells (3 cell type) according to the present invention was tested by the same test methods as described above.

The results are shown in Table 5.

**[Table 5]**

| entry | Dye a | Substrate 2A (Substrate Number) | (2 Cell Type) Conversion Efficiency η(%) | (3 Cell Type) Conversion Efficiency η(%) |
|---|---|---|---|---|
| 1 | CMY-003 | 1 | 5.0 | 5.5 |
| 2 | CMO-007 | 1 | 5.8 | 6.8 |
| 3 | CMY-003 | 2 | 4.6 | 5.1 |
| 4 | CMY-003 | 3 | 3.5 | 3.7 |
| 5 | CMY-003 | 4 | 6.5 | 7.1 |
| 6 | CMY-003 | 5 | 4.5 | 4.9 |
| 7 | CMY-003 | 7 | 5.4 | 6.4 |
| 8 | CMO-007 | 7 | 3.4 | 3.9 |
| 9 | CMY-003 | 8 | 3.5 | 3.8 |

In Table 5, the tandem solar cells (2 cell type) were fabricated by respectively combining a photoelectric conversion element fabricated by supporting Dye a on the porous substrates with substrate numbers of 1 to 11 listed as "Substrate 2A", and a photoelectric conversion element fabricated by supporting N719 as the dye on a porous substrate with substrate number 10.
Further, the tandem solar cells (3 cell type) were similarly fabricated by respectively combining the photoelectric conversion element listed as "Substrate 2A", and a photoelectric conversion element fabricated by respectively supporting N719 on the titanium oxide face and NKC-001 on the tin oxide face of the porous substrate with substrate number 12.

In Table 5, "Substrate 2A" denotes a substrate used for a conductive glass support (substrate) having a thin film of oxide semiconductor fine particles, specifically, the above-described "first face". Here, the substrate number in Substrate 2A has the same meaning as above.
"Dye a" means the dye which is supported on the thin film of oxide semiconductor fine particles.
Among the Substrates 2A, the substrate with substrate number 7 was fabricated using the oxide semiconductor fine particles prepared in the same manner as in the above-described Example 7. The ratio of the respective metals in the oxide semiconductor fine particles is, in terms of mass ratio of the respective metal atoms, about 2.4/1 for titanium to zirconium. Similarly, the substrate with substrate number 8 was 1.2/1 for titanium to zirconium.

It is clear from the results of Table 5 that the conversion efficiency η of a tandem solar cell (2 cell type) exhibited a clearly higher value than the conversion efficiency for any of the corresponding single cells, thereby it was confirmed that photoelectric conversion efficiency per unit surface area can be improved by making into a tandem type.
Further, from a comparison of the respective conversion efficiencies of 2 cell and 3 cell type tandem solar cells, the 3 cell type exhibited a higher conversion efficiency value than the 2 cell type in all cases. Thus, it was confirmed that even when made into a 3 cell type, the tandem solar cell according to the present invention can exhibit sufficient effects, and that photoelectric conversion efficiency per unit surface area can be improved even more than that for the 2 cell type.
In other words, conversion efficiency for the 2 cell type tandem solar cells was 3.4 to 6.4%, whereas conversion efficiency for the 3 cell type tandem solar cells was 3.7 to 7.1%. Thus, it was confirmed that by making into a 3 cell type structure, light in the short-wavelength region, the medium-wavelength region, and the long-wavelength region was absorbed even more efficiently than for a 2 cell type, and that there is an effect in increasing the photoelectric conversion efficiency.

The fabrication methods for the solar cells (A) to (I) in the present invention will now be described.

### Solar Cell (A)

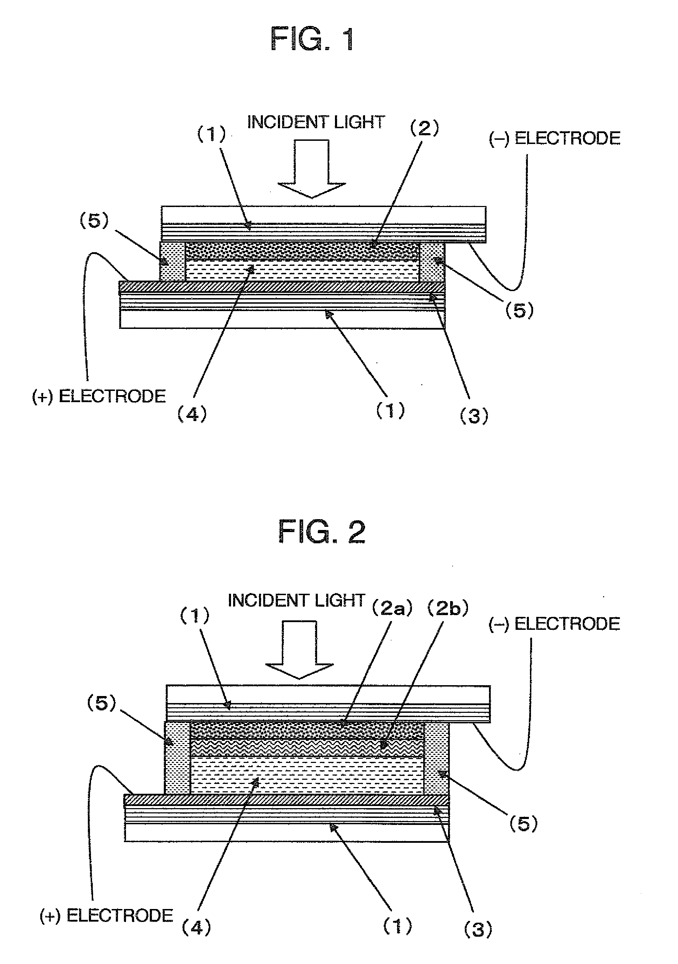

As shown in Fig. 1 (Solar Cell (A)), a paste formed from oxide semiconductor fine particles was coated on the conductive substance FTO of a conductive glass support (1). The coated substrate was baked for 30 minutes at 450°C, and then dipped into a 3.2 × 10⁻⁴ M solution of a dye for 24 hours to produce a thin film (2) of oxide semiconductor fine particles supporting the dye.
Next, Pt was vapor-deposited to 20 angstrom on the conductive substance FTO of a conductive glass support (1) to produce a platinum electrode (3). They were pasted to each other by using a sealing agent (5), and an iodine charge transport layer (4) was charged between (2) and (3) from an injection aperture (not shown) of the charge transport layer (4) between both electrodes. Then, the injection aperture was sealed with a sealant to obtain the solar cell (A) according to the present invention.

### Solar Cell (B)

As shown in Fig. 2 (Solar Cell (B)), a paste formed from first oxide semiconductor fine particles was coated on the conductive substance FTO of a conductive glass support (1). The coated substrate was dried for 30 minutes at 170°C, and then a paste formed from second oxide semiconductor fine particles was coated thereon. The coated substrate was baked for 30 minutes at 450°C, and then dipped into a 3.2 × 10⁻⁴ M solution of a first dye and a 3.2 × 10⁻⁴ M solution of a second dye for 24 hours each to produce a thin film (2a) of the first oxide semiconductor fine particles supporting the first dye and a thin film (2b) of the second oxide semiconductor supporting the second dye.
Next, Pt was vapor-deposited to 20 angstrom on the conductive substance FTO of a conductive glass support (1) to produce a platinum electrode (3). They were pasted to each other by a sealing agent (5), and an iodine charge transport layer (4) was charged between (2) and (3) from an injection aperture (not shown) of the charge transport layer (4) between both electrodes. Then, the injection aperture was sealed with a sealant to obtain the solar cell (B) according to the present invention.

### Solar Cell (C)

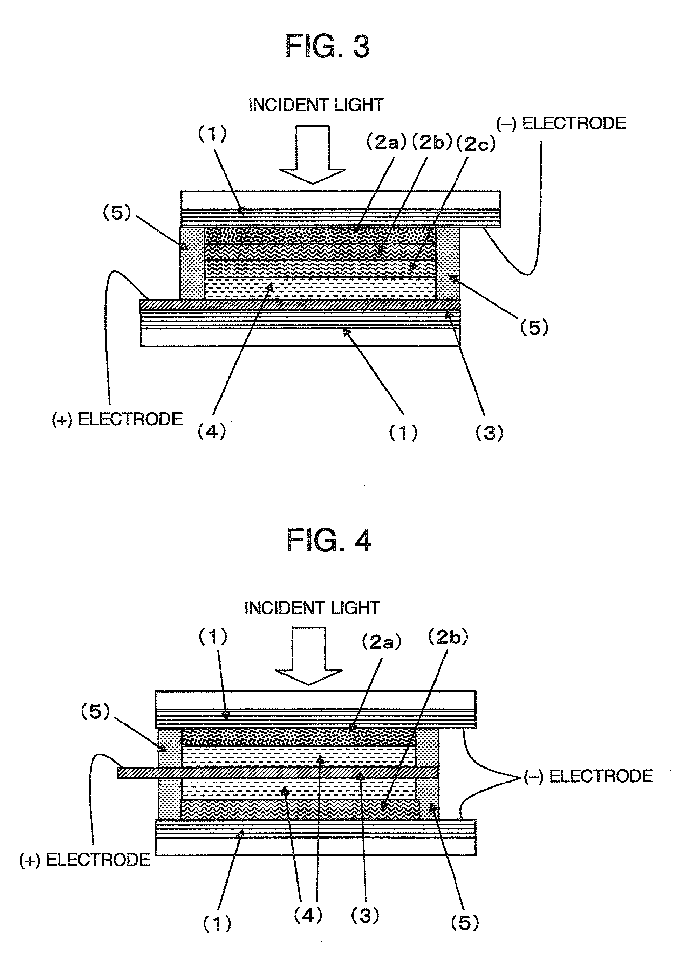

As shown in Fig. 3 (Solar Cell (C)), a paste formed from first oxide semiconductor fine particles was coated on the conductive substance FTO of a conductive glass support (1). The coated substrate was dried for 30 minutes at 170°C, and then a paste formed from second oxide semiconductor fine particles was coated thereon. The coated substrate was dried for 30 minutes at 170°C, and then a paste formed from third oxide semiconductor fine particles was coated thereon. The coated substrate was baked for 30 minutes at 450°C, and then dipped into a 3.2 × 10⁻⁴ M solution of a first dye, a 3.2 × 10⁻⁴ M solution of a second dye, and a 3.2 × 10⁻⁴ M solution of a third dye for 24 hours each to produce a thin film (2a) of the first oxide semiconductor fine particles supporting the first dye, a thin film (2b) of the second oxide semiconductor supporting the second dye, and a thin film (2c) of the third oxide semiconductor fine particles supporting the third dye.
Next, Pt was vapor-deposited to 20 angstrom on the conductive substance FTO of a conductive glass support (1) to produce a platinum electrode (3). They were pasted to each other by a sealing agent (5), and an iodine charge transport layer (4) was charged between (2) and (3) from an injection aperture (not shown) of the charge transport layer (4) between both electrodes. Then, the injection aperture was sealed with a sealant to obtain the solar cell (C) according to the present invention.

### Solar Cell (D)

As shown in Fig. 4 (Solar Cell (D)), a paste formed from first oxide semiconductor fine particles was coated on the conductive substance FTO of a conductive glass support (1). The coated substrate was baked for 30 minutes at 450°C, and then dipped into a 3.2 × 10⁻⁴ M solution of a first dye for 24 hours to produce a thin film (2a) of the first oxide semiconductor supporting the first dye. In the same manner, a paste formed from second oxide semiconductor fine particles was coated on the conductive substance FTO of a conductive glass support (1). The coated substrate was baked for 30 minutes at 450°C, and then dipped into a 3.2 × 10⁻⁴ M solution of a second dye for 24 hours to produce a thin film (2b) of the second oxide semiconductor supporting the second dye.
Next, they were pasted to each other by a sealing agent (5) so that they opposed each other with a platinum mesh or carbon mesh (3) sputtered with platinum between them. An iodine charge transport layer (4) was charged between (2a) and (2b) from an injection aperture (not shown) of the charge transport layer (4). Then, the injection aperture was sealed with a sealant to obtain the solar cell (D) according to the present invention.

### Solar Cell (E)

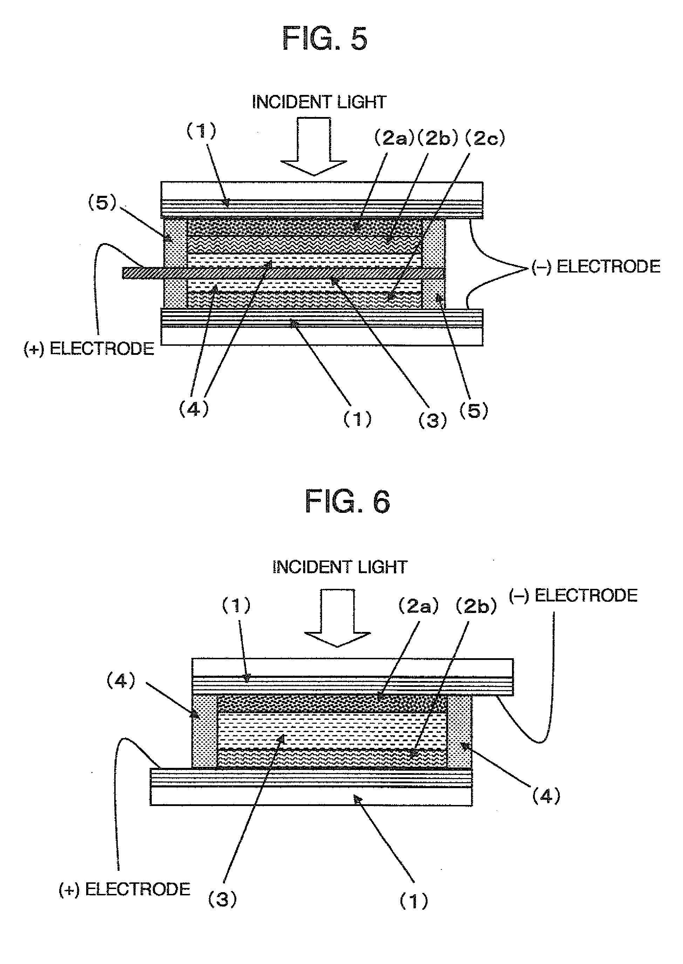

As shown in Fig. 5 (Solar Cell (E)), a paste formed from first oxide semiconductor fine particles was coated on the conductive substance FTO of a conductive glass support (1). The coated substrate was dried for 30 minutes at 170°C, and then a paste formed from second oxide semiconductor fine particles was coated thereon. The coated substrate was baked for 30 minutes at 450°C, and then dipped into a 3.2 × 10⁻⁴ M solution of a first dye and a 3.2 × 10⁻⁴ M solution of a second dye for 24 hours each to produce a thin film (2a) of the first oxide semiconductor supporting the first dye and a thin film (2b) of the second oxide semiconductor supporting the second dye. In the same manner, a paste formed from third oxide semiconductor fine particles was coated on the conductive substance FTO of a conductive glass support (1). The coated substrate was baked for 30 minutes at 450°C, and then dipped into a 3.2 × 10⁻⁴ M solution of a third dye for 24 hours to produce a thin film (2c) of the third oxide semiconductor supporting the third dye.
Next, they were pasted to each other by a sealing agent (5) so that they opposed each other with a platinum mesh or carbon mesh (3) sputtered with platinum between them. An iodine charge transport layer (4) was charged between (2a) and (2b), and (2c) from an injection aperture (not shown) of the charge transport layer (4). Then, the injection aperture was sealed with a sealant to obtain the solar cell (E) according to the present invention.

### Solar Cell (F)

As shown in Fig. 6 (Solar Cell (F)), a paste formed from first oxide semiconductor fine particles was coated on the conductive substance FTO of a conductive glass support (1). The coated substrate was dried for 30 minutes at 170°C, and then a paste formed from second oxide semiconductor fine particles was coated thereon. The coated substrate was baked for 30 minutes at 450°C, and then dipped into a 3.2 × 10⁻⁴ M solution of a first dye and a 3.2 × 10⁻⁴ M solution of a second dye for 24 hours each to produce a thin film (2a) of the first oxide semiconductor supporting the first dye and a thin film (2b) of the second oxide semiconductor supporting the second dye. In the same manner, a paste formed from third oxide semiconductor fine particles was coated on the conductive substance FTO of a conductive glass support (1). The coated substrate was baked for 30 minutes at 450°C, and then dipped into a 3.2 × 10⁻⁴ M solution of a third dye for 24 hours to produce a thin film (2c) of the third oxide semiconductor supporting the third dye.
Next, they were pasted to each other by a sealing agent (5), and an iodine charge transport layer (4) was charged between (2a) and (2b) from an injection aperture (not shown) of the charge transport layer (4) between both electrodes. Then, the injection aperture was sealed with a sealant to obtain the solar cell (F) according to the present invention.

### Solar Cell (G)

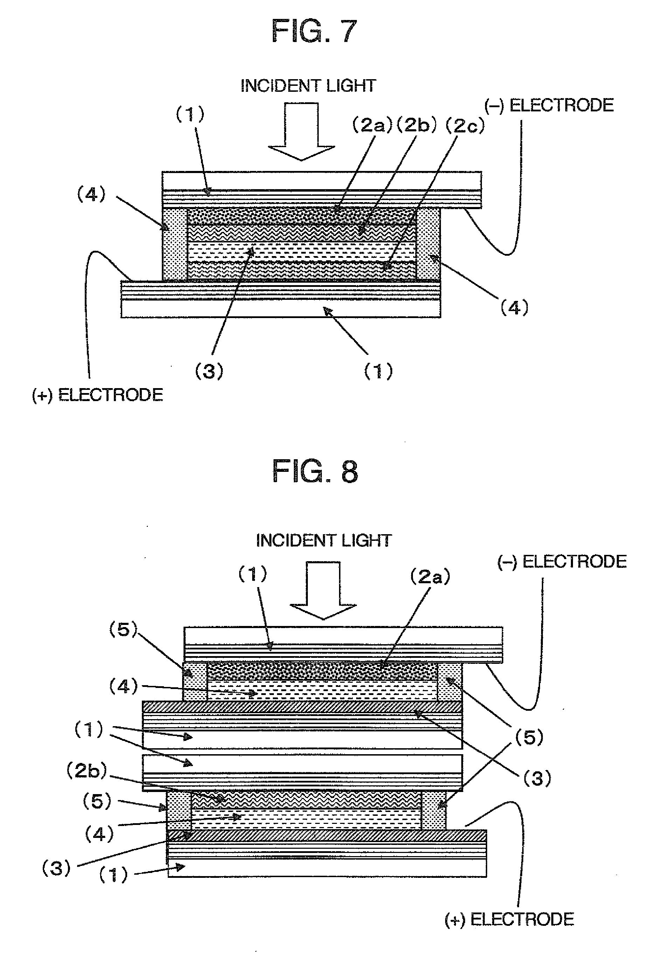

As shown in Fig. 7 (Solar Cell (G)), a paste formed from first oxide semiconductor fine particles was coated on the conductive substance FTO of a conductive glass support (1). The coated substrate was dried for 30 minutes at 170°C, and then a paste formed from second oxide semiconductor fine particles was coated thereon. The coated substrate was baked for 30 minutes at 450°C, and then dipped into a 3.2 × 10⁻⁴ M solution of a first dye and a 3.2 × 10⁻⁴ M solution of a second dye for 24 hours each to produce a thin film (2a) of the first oxide semiconductor supporting the first dye and a thin film (2b) of the second oxide semiconductor supporting the second dye. In the same manner, a paste formed from third oxide semiconductor fine particles was coated on the conductive substance FTO of a conductive glass support (1). The coated substrate was baked for 30 minutes at 450°C, and then dipped into a 3.2 × 10⁻⁴ M solution of a third dye for 24 hours to produce a thin film (2c) of the third oxide semiconductor supporting the third dye.
Next, they were pasted to each other by a sealing agent (5), and an iodine charge transport layer (4) was charged between (2a), (2b) and (2c) from an injection aperture (not shown) of the charge transport layer (4) between both electrodes. Then, the injection aperture was sealed with a sealant to obtain the solar cell (G) according to the present invention.

### Solar Cell (H)

As shown in Fig. 8 (Solar Cell (H)), a paste formed from first oxide semiconductor fine particles was coated on the conductive substance FTO of a conductive glass support (1). The coated substrate was baked for 30 minutes at 450°C, and then dipped into a 3.2 × 10⁻⁴ M solution of a first dye for 24 hours to produce a thin film (2a) of the first oxide semiconductor fine particles supporting the first dye. In the same manner, a paste formed from second oxide semiconductor fine particles was coated on the conductive substance FTO of a conductive glass support (1). The coated substrate was baked for 30 minutes at 450°C, and then dipped into a 3.2 × 10⁻⁴ M solution of a second dye for 24 hours to produce a thin film (2b) of the second oxide semiconductor fine particles supporting the second dye.
Next, Pt was vapor-deposited to 20 angstrom on the conductive substance FTO of a conductive glass support (1) to produce a platinum electrode (3). They were each pasted by a sealing agent (5), and an iodine charge transport layer (4) was charged between (2) and (3) from an injection aperture (not shown) of the charge transport layer (4) between the electrodes. Then, the injection aperture was sealed with a sealant to obtain 2 solar cells. These solar cells were arranged vertically with respect to the incident light and connected in series to obtain a solar cell (H) according to the present invention.

### Solar Cell (I)

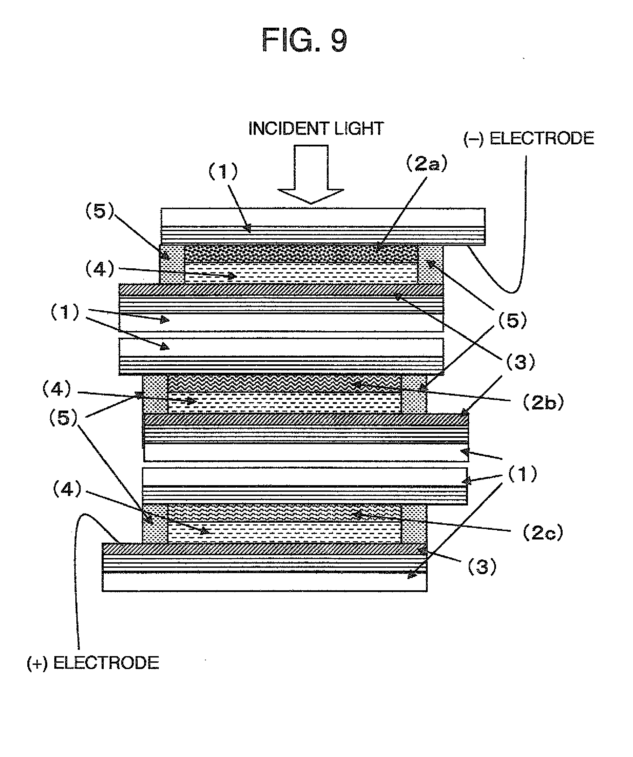

As shown in Fig. 9 (Solar Cell (I)), a paste formed from first oxide semiconductor fine particles was coated on the conductive substance FTO of a conductive glass support (1). The coated substrate was baked for 30 minutes at 450°C, and then dipped into a 3.2 × 10⁻⁴ M solution of a first dye for 24 hours to produce a thin film (2a) of the first oxide semiconductor fine particles supporting the first dye. In the same manner, a paste formed from second oxide semiconductor fine particles was coated on the conductive substance FTO of a conductive glass support (1). The coated substrate was baked for 30 minutes at 450°C, and then dipped into a 3.2 × 10⁻⁴ M solution of a second dye for 24 hours to produce a thin film (2b) of the second oxide semiconductor fine particles supporting the second dye. In the same manner, a paste formed from third oxide semiconductor fine particles was coated on the conductive substance FTO of a conductive glass support (1). The coated substrate was baked for 30 minutes at 450°C, and then dipped into a 3.2 × 10⁻⁴ M solution of a third dye for 24 hours to produce a thin film (2c) of the second oxide semiconductor fine particles supporting the third dye.
Next, Pt was vapor-deposited to 20 angstrom on the conductive substance FTO of a conductive glass support (1) to produce a platinum electrode (3). They were each pasted by a sealing agent (5), and an iodine charge transport layer (4) was charged between (2) and (3) from an injection aperture (not shown) of the charge transport layer (4) between the electrodes. Then, the injection aperture was sealed with a sealant to obtain 3 solar cells. These solar cells were arranged vertically with respect to the incident light and connected in series to obtain a solar cell (I) according to the present invention.

Subsequently, concerning solar cells (A), (D), (H), and (I), combinations of dyes, oxide semiconductors, and composite oxide semiconductors, and the photoelectric conversion performance (open-circuit voltage) of tandem cells using such combinations, were evaluated. The results are shown in the following Table 6.

**[Table 6-1]**

| Example Number | Cell | Semiconductor Layer Number | Oxide Semiconductor | Dye | Voc/V | Electrolytic Solution |
|---|---|---|---|---|---|---|
| Example 14 | A | (2) | Mg(0.05) | S-1 | 0.91 | B |
| Example 15 | A | (2) | Mg(0.10) | S-1 | 1.01 | B |
| Example 16 | A | (2) | Mg(0.15) | S-1 | 0.91 | B |
| Example 17 | A | (2) | Mg(0.20) | S-1 | 0.95 | B |
| Example 18 | A | (2) | Ca(0.10) | S-1 | 0.90 | B |
| Example 19 | A | (2) | Ca(0.20) | S-1 | 0.89 | B |
| Example 20 | A | (2) | Ca(0.30) | S-1 | 0.93 | B |
| Example 21 | A | (2) | Sr(0.10) | S-1 | 0.92 | B |
| Example 22 | A | (2) | Mg(0.05) | S-2 | 0.86 | B |
| Example 23 | A | (2) | Mg(0.10) | S-2 | 0.91 | B |
| Example 24 | A | (2) | Mg(0.15) | S-2 | 0.89 | B |
| Example 25 | A | (2) | Mg(0.20) | S-2 | 0.88 | B |
| Example 26 | A | (2) | Ca(0.10) | S-2 | 0.87 | B |
| Example 27 | A | (2) | Ca(0.20) | S-2 | 0.87 | B |
| Example 28 | A | (2) | Ca(0.30) | S-2 | 0.87 | B |
| Example 29 | A | (2) | Sr(0.10) | S-2 | 0.87 | B |
| Example 30 | A | (2) | Mg(0.05) | S-3 | 0.95 | B |
| Example 31 | A | (2) | Mg(0.10) | S-3 | 0.96 | B |
| Example 32 | A | (2) | Mg(0.15) | S-3 | 0.98 | B |
| Example 33 | A | (2) | Mg(0.20) | S-3 | 0.97 | B |
| Example 34 | A | (2) | Ca(0.10) | S-3 | 0.95 | B |
| Example 35 | A | (2) | Ca(0.20) | S-3 | 0.94 | B |
| Example 36 | A | (2) | Ca(0.30) | S-3 | 0.93 | B |
| Example 37 | A | (2) | Sr(0.10) | S-3 | 0.92 | B |
| Example 38 | A | (2) | Mg(0.05) | S-4 | 0.82 | A |
| Example 39 | A | (2) | Mg(0.10) | S-4 | 0.86 | A |
| Example 40 | A | (2) | Mg(0.15) | S-4 | 0.86 | A |
| Example 41 | A | (2) | Mg(0.05) | M-7 | 0.78 | A |
| Example 42 | A | (2) | Mg(0.10) | M-7 | 0.79 | A |
| Example 43 | A | (2) | Mg(0.15) | M-7 | 0.79 | A |
| Example 44 | A | (2) | Mg(0.20) | M-7 | 0.79 | A |
| Example 45 | A | (2) | Ca(0.10) | M-7 | 0.77 | A |
| Example 46 | A | (2) | Ca(0.20) | M-7 | 0.74 | A |
| Example 47 | A | (2) | Ca(0.30) | M-7 | 0.74 | A |
| Example 48 | A | (2) | Sr(0.10) | M-7 | 0.76 | A |
| Example 49 | A | (2) | Mg(0.20) | M-3 | 0.72 | A |
| Example 50 | A | (2) | Mg(0.10) | M-4 | 0.52 | B |

**[Table 6-2]**

| Example Number | Cell | Semiconductor Layer Number | Oxide Semiconductor | Dye | Voc/V | Electrolytic Solution |
|---|---|---|---|---|---|---|
| Example 51 | A | (2) | Mg(0.20) | M-4 | 0.52 | B |
| Example 52 | A | (2) | Can(0.20) | M-4 | 0.51 | B |
| Example 53 | A | (2) | Mg(0.10) | M-5 | 0.44 | B |
| Example 54 | A | (2) | Ca(0.20) | M-5 | 0.43 | B |
| Example 55 | A | (2) | Mg(0.10) | L-1 | 0.43 | B |
| Example 56 | D | (2a) | Mg(0.10) | S-1 | 0.74 | A |
| | | (2b) | TiO₂ | M-7 | | |
| Example 57 | D | (2a) | TiO₂ | M-7 | 0.75 | A |
| | | (2b) | Mg(0.10) | S-1 | | |
| Example 58 | D | (2a) | Mg(0.10) | S-1 | 0.75 | B |
| | | (2b) | TiO₂ | M-3 | | |
| Example 59 | D | (2a) | Mg(0.10) | S-1 | 0.81 | B |
| | | (2b) | Mg(0.10) | M-3 | | |
| Example 60 | D | (2a) | Mg(0.10) | M-3 | 0.79 | B |
| | | (2b) | Mg(0.10) | S-1 | | |
| Example 61 | H | (2a) | Mg(0.10) | S-1 | 1.75 | B |
| | | (2b) | Mg(0.20) | M-1 | | A |
| Example 62 | H | (2a) | Mg(0.10) | S-1 | 1.68 | B |
| | | (2b) | ZnOSnO₂ | M-2 | | A |
| Example 63 | H | (2a) | Mg(0.10) | S-1 | 1.69 | B |
| | | (2b) | TiO₂ | M-7 | | A |
| Example 64 | H | (2a) | Mg(0.10) | S-1 | 1.75 | B |
| | | (2b) | TiO₂ | S-4 | | A |
| Example 65 | H | (2a) | Mg(0.10) | M-7 | 1.21 | B |
| | | (2b) | TiO₂(rutile) | L-1 | | B |
| Example 66 | I | (2a) | Mg(0.10) | S-1 | 2.05 | B |
| | | (2b) | TiO₂ | M-5 | | A |
| | | (2c) | TiO₂(rutile) | L-1 | | B |
| Example 67 | I | (2a) | Sr(0.10) | S-3 | 1.96 | B |
| | | (2b) | TiO₂ | M-7 | | A |
| | | (2c) | SnO₂ | L-1 | | B |
| Example 68 | I | (2a) | Mg(0.10) | S-1 | 2.15 | B |
| | | (2b) | Mg(0.20) | M-1 | | A |
| | | (2c) | TiO₂ | M-5 | | A |
| Example 69 | I | (2a) | Mg(0.10) | S-1 | 2.13 | B |
| | | (2b) | Mg(0,20) | M-3 | | A |
| | | (2c) | TiO₂ | L-1 | | B |

**[Table 6-3]**

| Example Number | Cell | Semiconductor Layer Number | Oxide Semiconductor | Dye | Voc/V | Electrolytic Solution |
|---|---|---|---|---|---|---|
| Comparative Example 1 | A | (2) | TiO₂ | S-1 | 0.82 | B |
| Comparative Example 2 | A | (2) | TiO₂ | S-2 | 0.83 | B |
| Comparative Example 3 | A | (2) | TiO₂ | S-3 | 0.75 | B |
| Comparative Example 4 | A | (2) | TiO₂ | S-4 | 0.74 | A |
| Comparative Example 5 | A | (2) | TiO₂ | M-7 | 0.68 | A |
| Comparative Example 6 | A | (2) | TiO₂ | M-3 | 0.65 | A |
| Comparative Example 7 | A | (2) | TiO₂ | M-4 | 0.50 | B |
| Comparative Example 8 | A | (2) | TiO₂ | M-5 | 0.40 | B |
| Comparative Example 9 | A | (2) | TiO₂ | L-1 | 0.41 | B |
| Comparative Example 10 | D | (2a) | TiO₂ | S-1 | 0.74 | A |
| | | (2b) | TiO₂ | M-7 | | |
| Comparative Example 11 | D | (2a) | TiO₂ | M-7 | 0.73 | A |
| | | (2b) | TiO₂ | S-1 | | |
| Comparative Example 12 | H | (2a) | TiO₂ | S-1 | 1.45 | B |
| | | (2b) | TiO₂ | M-7 | | A |
| Comparative Example 13 | I | (2a) | TiO₂ | S-1 | 1.81 | B |
| | | (2b) | TiO₂ | M-7 | | A |
| | | (2c) | TiO₂ | L-1 | | B |
| Comparative Example 14 | I | (2a) | TiO₂ | S-1 | 1.82 | B |
| | | (2b) | TiO₂ | M-3 | | A |
| | | (2c) | TiO₂ | L-1 | | B |

From the above Table 6, the following schemes are possible.
In Examples 14 to 55 and Comparative Examples 1 to 9, a large improvement in open-circuit voltage (Voc) as a result of using titanium oxide as the composite oxide of the present invention was observed for all of the dyes (S-1, S-2, S-3, S-4, M-7, M-3, M-4, M-5, and L-1) used in the single-structure solar cell (A). Further, in Examples 56 to 60 and Comparative Examples 10 and 11, the open-circuit voltage in the examples of the present invention substantially increased (compared with the comparative examples) with the parallel structure solar cell (D). In Examples 61 to 65 and Comparative Example 12, a substantial increase in open-circuit voltage in the examples of the present invention was observed with the series two-layer structure solar cell (H). In Examples 66 to 69 and Comparative Examples 13 and 14, a substantial increase in open-circuit voltage in the examples of the present invention was observed with the series three-layer structure solar cell (I).

Thus, by selecting and combining an oxide and a composite oxide semiconductor suited for each dye, a solar cell with a higher voltage can be obtained. In addition, by further stacking these cells together to be a tandem-structure, voltage can be improved with a small surface area without widening the surface area of the solar cell. A solar cell in which a high voltage can be obtained with a small surface area is suitable for portable applications such as in mobile phones and desktop calculators, or various applications for various kinds of display, such as liquid crystal, electroluminescence (EL), plasma display (PDP), and electronic paper (DP), which require a high voltage to drive them. By using the solar cell according to the present invention, such products may be made lighter and more compact. Further, by using the high-voltage solar cell according to the present invention for power charging applications such as lithium ion secondary batteries, nickel-hydrogen secondary batteries, capacitors, and condensers, high-voltage power charging can be carried out with little energy loss.

Next, concerning solar cell (D), combinations of dyes, oxide semiconductors, and composite oxide semiconductors, and the photoelectric conversion performance (short-circuit current) of tandem cells using such combinations, were evaluated. The results are shown in the following Table 7.

**[Table 7]**

| Example Number | Cell | Semiconductor Layer Number | Oxide Semiconductor | Dye | Isc/mA/cm² | Electrolytic solution |
|---|---|---|---|---|---|---|
| Example 70 | D | (2a) | Mg(0.10) | S-1 | 10.85 | A |
| | | (2b) | TiO₂ | M-7 | | |
| Comparative Example 15 | D | (2a) | TiO₂ | S-1 | 9.20 | A |
| | | (2b) | TiO₂ | M-7 | | |

From the above Table 7, the following schemes are possible.
From Example 70 and Comparative Example 15, an improvement in short-circuit current as a result of using the composite oxide of the present invention instead of titanium oxide as the semiconductor for the short-wavelength region was seen for the parallel structure solar cell (D).
Based on this, the solar cell according to the present invention can also improve short-circuit current and obtain a large current with a small surface area.

Thus, it was found that a tandem solar cell according to the present invention can exhibit sufficient effects for either the 2 cell type or the 3 cell type structure, and that such a tandem solar cell is an excellent solar cell.
In the present examples, as a 2 cell type, tandem solar cells were fabricated which combined photoelectric conversion elements for the short-wavelength region and the medium-wavelength region (photoelectric conversion elements fabricated using a porous substrate supporting a dye having a maximum absorption wavelength in the short-wavelength region or medium-wavelength region).
Further, as a 3 cell type, tandem solar cells were fabricated by combining photoelectric conversion elements for the short-wavelength region, the medium-wavelength region, and the long-wavelength region (a photoelectric conversion element fabricated using a porous substrate supporting a dye having a maximum absorption wavelength in the short-wavelength region, and a photoelectric conversion element fabricated using a single sheet of a porous substrate supporting dyes having a maximum absorption wavelength in the medium-wavelength region and the long-wavelength region on either respective face of the substrate). However, these photoelectric conversion elements for the short-wavelength region, the medium-wavelength region, and the long-wavelength region are not especially limited to such a combination. The tandem solar cell may be fabricated using any combination thereof. Thus, a solar cell using any combination is included in the present invention.

The dyes used in the solar cell according to the present invention will now be illustrated.

The dyes used for the short-wavelength region in the examples are illustrated below.

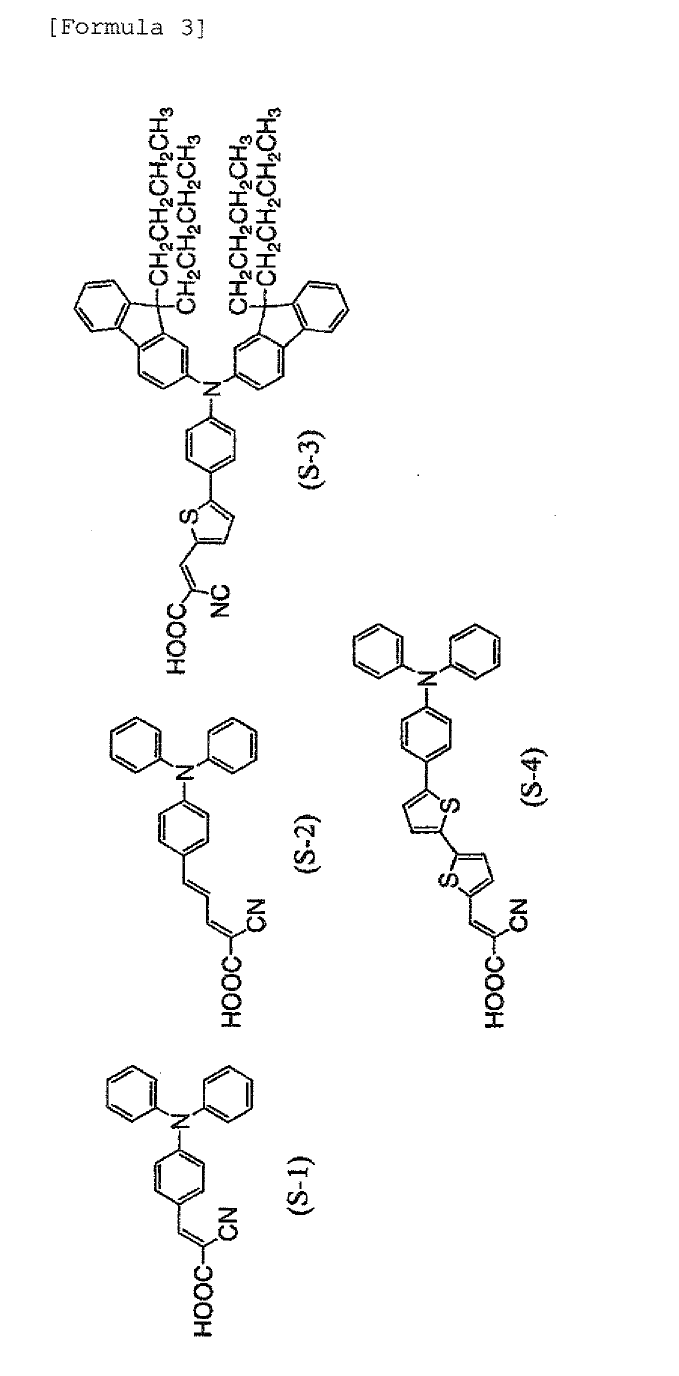

The dyes used for the medium-wavelength region in the examples are illustrated below.

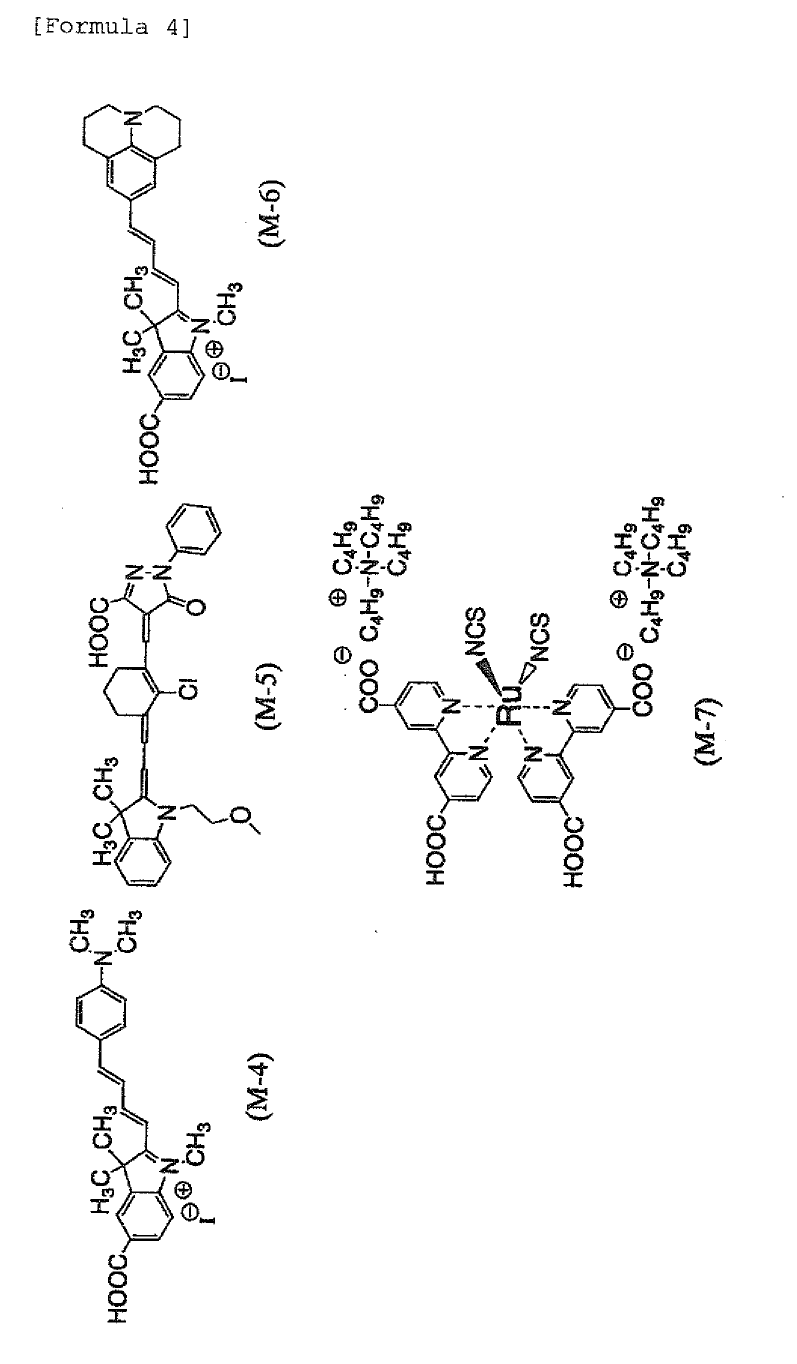

The dyes used for the long-wavelength region in the examples are illustrated below.

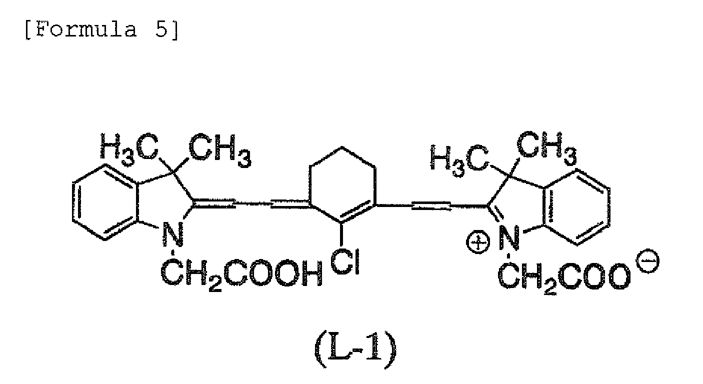

### INDUSTRIAL APPLICABILITY

The solar cell according to the present invention is effectively utilized over a wide field as a solar cell with a high conversion efficiency, especially the conversion efficiency in the short-wavelength region and the long-wavelength region.

### BRIEF DESCRIPTION OF THE DRAWINGS

Fig. 1 is a schematic diagram illustrating the structural configuration of a single-structure solar cell (A) of the present invention;
Fig. 2 is a schematic diagram illustrating the structural configuration of a tandem-structure solar cell (B) of the present invention;
Fig. 3 is a schematic diagram illustrating the structural configuration of a tandem-structure solar cell (C) of the present invention;
Fig. 4 is a schematic diagram illustrating the structural configuration of a tandem-structure solar cell (D) of the present invention;
Fig. 5 is a schematic diagram illustrating the structural configuration of a tandem-structure solar cell (E) of the present invention;
Fig. 6 is a schematic diagram illustrating the structural configuration of a tandem-structure solar cell (F) of the present invention;
Fig. 7 is a schematic diagram illustrating the structural configuration of a tandem-structure solar cell (G) of the present invention;
Fig. 8 is a schematic diagram illustrating the structural configuration of a tandem-structure solar cell (H) of the present invention; and
Fig. 9 is a schematic diagram illustrating the structural configuration of a tandem-structure solar cell (I) of the present invention.

## Claims

1. A solar cell comprising a combination of at least 2 different photoelectric conversion elements for a specific wavelength region, each comprising a dye or a salt thereof having a maximum absorption wavelength in a specific wavelength region supported on a thin film of oxide semiconductor fine particles provided on a substrate.

2. The solar cell according to claim 1, wherein the specific wavelength region is a wavelength region selected from a short-wavelength region, a medium-wavelength region, and a long-wavelength region.

3. The solar cell according to claim 1, wherein a material of the oxide semiconductor fine particles comprises at least 1 metal species, and when 2 or more metal species are present, the metal species are combined at a specific mass ratio.

4. A photoelectric conversion element for a specific wavelength region, comprising a dye or a salt thereof having a maximum absorption wavelength in a specific wavelength region supported on a thin film of oxide semiconductor fine particles provided on a substrate.

5. The photoelectric conversion element according to claim 4, wherein a material of the oxide semiconductor fine particles comprises at least 1 metal species, and when 2 or more metal species are present, the metal species are combined at a specific mass ratio.

6. The photoelectric conversion element according to claim 5, wherein in a thin film of oxide semiconductor fine particles comprising 2 or more materials, at least 1 of the materials is titanium oxide, and the mass ratio of titanium oxide in terms of the total mass of the materials of the oxide semiconductor fine particles is 70 to 98 mass%.

7. The photoelectric conversion element according to claim 6, wherein the oxide semiconductor fine particles are composite oxide semiconductor fine particles of titanium oxide with an alkaline earth metal or a transition metal, or composite oxide semiconductor fine particles of titanium oxide with a metal oxide.

8. The photoelectric conversion element according to claim 7, wherein the alkaline earth metal is either Mg (magnesium) or Ca (calcium), and the transition metal is any of Zr (zirconium), Nb (niobium), V (vanadium), Zn (zinc), Sn (tin), Fe (Iron), Ge (germanium), W (tungsten), or Mo (molybdenum).

9. The photoelectric conversion element according to claim 7, wherein the alkaline earth metal is Sr (strontium) or Ba (barium).

10. The photoelectric conversion element according to claim 8, comprising a dye or a salt thereof having a maximum absorption wavelength in a short-wavelength region of 300 to 450 nm supported on oxide semiconductor fine particles comprising a composite oxide of titanium oxide with Mg (magnesium), Ca (calcium), or Zr (zirconium).

11. The photoelectric conversion element according to claim 9, comprising a dye or a salt thereof having a maximum absorption wavelength in a short-wavelength region of 300 to 450 nm supported on oxide semiconductor fine particles comprising a composite oxide of titanium oxide with Sr (strontium) or Ba (barium).

12. A solar cell having 2 thin film layers formed from different kinds of oxide semiconductor fine particles.

13. The solar cell according to claim 12, wherein either of the 2 layers is a thin film layer of composite oxide semiconductor fine particles of titanium oxide with an alkaline earth metal, a transition metal, or a metal oxide.

14. The solar cell according to claim 13, wherein the composite oxide semiconductor fine particles of titanium oxide with an alkaline earth metal, a transition metal, or a metal oxide are a composite oxide semiconductor of titanium oxide with Mg (magnesium).

15. The solar cell according to claim 13, comprising a dye having a maximum absorption wavelength in a short-wavelength region of 300 to 450 nm supported on composite oxide semiconductor fine particles of titanium oxide with an alkaline earth metal, a transition metal, or a metal oxide.

16. The solar cell according to claim 13, having a thin film layer of composite oxide semiconductor fine particles of titanium oxide with an alkaline earth metal, a transition metal, or a metal oxide, and a thin film layer of oxide semiconductor fine particles comprising titanium oxide fine particles.

17. A solar cell having 2 thin film layers formed from the same kind of oxide semiconductor fine particles, and 1 thin film layer formed from a different kind of oxide semiconductor fine particles.

18. A solar cell having 3 thin film layers, each formed from different kinds of oxide semiconductor fine particles.

19. The solar cell according to claim 17 or 18, wherein any one of the 3 layers is a thin film layer of composite oxide semiconductor fine particles of titanium oxide with an alkaline earth metal, a transition metal, or a metal oxide.

20. The solar cell according to claim 19, comprising a dye having a maximum absorption wavelength in a short-wavelength region of 300 to 450 nm supported on composite oxide semiconductor fine particles of titanium oxide with an alkaline earth metal, a transition metal, or a metal oxide.

21. The solar cell according to claim 17 or 18, wherein any one of the 3 layers is a thin film layer of oxide semiconductor fine particles comprising titanium oxide.

22. The solar cell according to claim 21, comprising a dye having a maximum absorption wavelength in a medium-wavelength region of 450 to 750 nm supported on oxide semiconductor fine particles comprising titanium oxide.

23. The solar cell according to claim 17 or 18, comprising different dyes or salts thereof supported on each of the 3 thin film layers formed from oxide semiconductor fine particles.

24. The solar cell according to any one of claims 12, 17, or 18, wherein the 2 or more thin film layers of oxide semiconductor fine particles have respectively independent charge transport material layers, and the charge transport material of each layer is different from each others.

25. The photoelectric conversion element according to claim 5, having an open-circuit voltage of 0.85 V or more.

26. The photoelectric conversion element according to claim 5, having an open-circuit voltage of 0.90 V or more.
